# EUROPEAN PATENT APPLICATION

(11) **EP 2 778 587 A1**
(43) Date of publication of application: **17.09.2014**
(21) Application number: 14159571.0
(22) Date of filing: 13.03.2014
(51) Int. Cl.: F27B 5/04, F27B 5/14, F27B 5/18, F27B 17/00, F27D 19/00, F27D 21/00, F28C 3/00, F28D 1/047, F28F 1/32, H01L 21/67, H01L 21/677, F28D 21/00

(54) **Thermal diffusion chamber with convection compressor**

(30) Priority: 14.03.2013 US 201313803726
(71) Applicant: Poole Ventura, Inc., Oxnard, CA 93730 (US)
(72) Inventor: Erickson, Mark R., Newbury Park, CA 91320 (US); Poole, Henry J., Ventura, CA 93001 (US); Jamshidi, Nader, Newbury Park, CA 91320 (US); Custer, III, Arthur W., Oxnard, CA 93036 (US); Dingus, Aaron L., Moorpark, CA 93021 (US)
(74) Representative: Walker, Ross Thomson

(57) **Abstract**

Preferably, a frame supporting a containment chamber, with a sealed process chamber confined within the containment chamber, and at least one fluid inlet structure in fluidic communication with an exterior of the sealed process chamber, the fluid inlet structure including at least a flow adjustment structure to control a fluid flow from a fluid source around the exterior of the sealed process chamber; and an open loop fluid convection system in fluidic communication with an interior of the sealed process chamber, wherein the fluid convection system includes a rotary compressor assembly that extends into the sealed process chamber is disclosed.

## Description

### Field of the Invention

The claimed invention relates to the field of thermal diffusion chamber equipment and methods of making thermal diffusion chambers for the production of solar energy panels, and more particularly to structures and methods of a obtaining a more even thermal profile of substrates confined within the thermal diffusion chamber.

### Background

A form of solar energy production relies on solar panels, which in turn rely on the diffusion of select materials onto a substrate. In one example, glass is used as the substrate, which is exposed to a gaseous selenide species to form a copper, indium and selenide containing film on the substrate. The gaseous selenide species is known to be toxic to humans, which underscores prudent handling methods, including thermal regulation systems.

As such, thermal regulation systems capable of precluding migration and leakage of the gaseous selenide species from within a process chamber to atmosphere, in an efficient and reliable manner, can greatly improve the operation and production output of thermal chambers used in providing substrates of copper, indium and selenide containing film diffused within them.

Accordingly, there is a continuing need for improved mechanisms and methods of thermal regulation of the process chamber for thermal diffusion chambers.

### Summary of the Invention

In accordance with various exemplary embodiments, preferably, a frame supporting a containment chamber, with a process chamber confined within the containment chamber, and at least one fluid inlet structure in fluidic communication with an exterior of the sealed process chamber, the fluid inlet structure including at least a flow adjustment structure to control a fluid flow from a fluid source around the exterior of the process chamber is provided. Preferably, the exemplary embodiment further provides an open loop fluid convection system in fluidic communication with an interior of the process chamber, wherein the fluid convection system includes a rotary compressor assembly that extends into the process chamber, a controller communicating with the flow adjustment structure, and a control signal buss communicating with at least the flow adjustment structure, and the controller, the control signal buss sends a control signal to the flow adjustment structure in response to a measured internal temperature value of an interior of said process chamber, wherein the rotary compressor assembly includes a central shaft for rotation within the process chamber.

### Brief Description of the Drawings

FIG. 1 displays an orthogonal projection, with partial cut-away, of an exemplary embodiment of a thermal chamber of the claimed invention.
FIG. 2 provides an orthogonal projection of an exemplary substrate support frame configured for use with the exemplary embodiment of the thermal chamber of FIG. 1.
FIG. 3 shows a cross-sectional, right side elevation view of the exemplary embodiment of the thermal chamber of FIG. 1.
FIG. 4 illustrates a cross-sectional, front elevation view of the exemplary embodiment of the thermal chamber of FIG. 1 showing an exhaust manifold and conduit.
FIG. 5 provides an enlarged detailed cross-sectional, elevation view of a fluid inlet structure with an attached inlet conduit of the exemplary embodiment of the thermal chamber of FIG. 1.
FIG. 6 depicts a cross-sectional, right side elevation view of the exemplary embodiment of the thermal chamber of FIG. 1, showing an exemplary closed loop internal heat exchanger.
FIG. 7 shows a cross-sectional, right side elevation view of the exemplary embodiment of the thermal chamber of FIG. 1, showing an exemplary open loop internal heat exchanger.
FIG. 8 depicts a cross-sectional, right side elevation view of the exemplary embodiment of the thermal chamber of FIG. 1, showing an exemplary internal thermal sensor.
FIG. 9 generally illustrates a plan view of an exemplary combination internal thermal sensor, open loop internal heat exchanger, and closed loop internal heat exchanger assembly of the thermal chamber of FIG. 1.
FIG. 10 displays an orthogonal projection, of an exemplary door with attached primary thermal deflection assembly, of the thermal chamber of FIG. 1.
FIG. 11 provides an orthogonal projection of the primary thermal dispersion assembly of FIG. 10.
FIG. 12 shows an orthogonal projection of a secondary thermal dispersion assembly of the thermal chamber of FIG. 1.
FIG. 13 illustrates a schematic of a cool down heat exchange system for use in cooling down the interior and exterior of the thermal chamber of FIG. 1.
FIG. 14 illustrates a plan view of an alternate exemplary combination internal thermal sensor, open loop internal heat exchanger, and closed loop internal heat exchanger assembly of the thermal chamber of FIG. 1.
FIG. 15 provides an end view of the alternate exemplary combination internal thermal sensor, open loop internal heat exchanger, and closed loop internal heat exchanger assembly of FIG. 14.
FIG. 16 displays a side elevation view of the alternate exemplary combination internal thermal sensor, open loop internal heat exchanger, and closed loop internal heat exchanger assembly of FIG. 14.
FIG. 17a shows an end view of the alternate exemplary combination internal thermal sensor, open loop internal heat exchanger, and closed loop internal heat exchanger assembly of FIG. 14 positioned within the thermal chamber of FIG. 1.
FIG. 17b shows a plan view of a bottom port support attached to the thermal chamber FIG. 17a.
FIG. 18 depicts a side elevation view of the alternate exemplary combination internal thermal sensor, open loop internal heat exchanger, and closed loop internal heat exchanger assembly of FIG. 14 positioned within the thermal chamber of FIG. 1.
FIG. 19 generally illustrates a flow chart of a method of forming an exemplary embodiment of the thermal chamber of FIG. 1.
FIG. 20 reveals a flow chart of a method of forming an exemplary embodiment of the thermal chamber of FIG. 1.
FIG. 21 shows a flow chart of a method of forming an alternate exemplary embodiment of the thermal chamber of FIG. 1.
FIG. 22 displays a flow chart of a method of forming an alternative exemplary embodiment of the thermal chamber of FIG. 1.
FIG. 23 reveals a flow chart of a method of forming an alternative alternate exemplary embodiment of the thermal chamber of FIG. 1.
FIG. 24 displays an orthogonal projection an exemplary embodiment of an open loop heat exchange system of the claimed invention.
FIG. 25 illustrates an orthogonal projection of a cooling tubes assembly of the exemplary embodiment of the open loop heat exchange system of FIG. 23.
FIG. 26 shows a right side view in elevation of the cooling tubes assembly of FIG. 23.
FIG. 27 depicts a right side view in elevation of a preferred embodiment of a cooling tubes assembly.
FIG. 28 illustrates a right side, cross section view of an embodiment of the cooling tubes assembly positioned within the process chamber of the thermal chamber.
FIG. 29 illustrates an orthogonal projection displays, of an exemplary embodiment of the thermal chamber of FIG. 1, with an open loop fluid convection system integrated therewith.
FIG. 30 shows a right side, partial cut-away view of the thermal chamber with the open loop fluid convection system of FIG. 25.
FIG. 31 depicts a right side, orthogonal projection of a substrate support frame supporting a plurality of substrates and communicating with a shroud.
FIG. 32 illustrates one of a pair of flow confinement covers of a convection conduit, in partial cut-away, enclosing the plurality of substrates of FIG. 21.
FIG. 33 displays an internal view of a rotary compressor assembly interacting with a door assembly of FIG. 25.
FIG. 34 reveals an external view of the rotary compressor assembly interacting with the door assembly of FIG. 33.
FIG. 35 shows a portion of the pair of flow confinement covers of the convection conduit, in partial cut-away, enclosing the plurality of substrates of FIG. 32.

FIG. 36 depicts a partial cut-away view of a door gurney communicating with the door of the process chamber of FIG. 1.

### Detailed Description of an Exemplary Embodiment of the Drawings

Reference will now be made in detail to one or more examples of various embodiments of the present invention depicted in the figures. Each example is provided by way of explanation of the various embodiments of the present invention, and not meant as a limitation of the invention. For example, features illustrated or described as part of one embodiment may be used with another embodiment to yield still a different embodiment. Other modifications and variations to the described embodiments are also contemplated within the scope and spirit of the claimed invention.

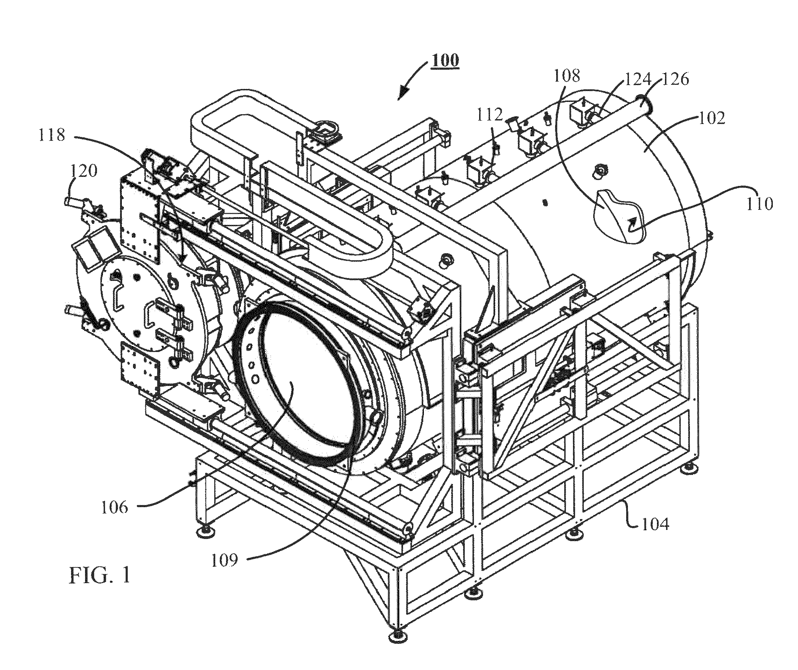

Turning to the drawings, FIG. 1 displays an exemplary thermal diffusion chamber 100 which includes at least a containment chamber 102 supported by a frame 104. The containment chamber 102 in turn supports a process chamber 106, which is preferably formed from quartz, but may alternatively be formed from titanium or a titanium alloy.

Preferably the exemplary thermal diffusion chamber 100 further includes a heat source module 108 disposed between the process chamber 106 and the containment chamber 102, a thermal regulation cavity 110 formed between the process chamber 106 and the heat source module 108, and a collar 109 secured to a lip of the process chamber 106 and anchored to the containment chamber 102. FIG. 1 further shows that at least one fluid inlet box 112 (also referred to herein as a fluid inlet structure 112) is provided, which is in fluidic communication with the thermal regulation cavity 110.

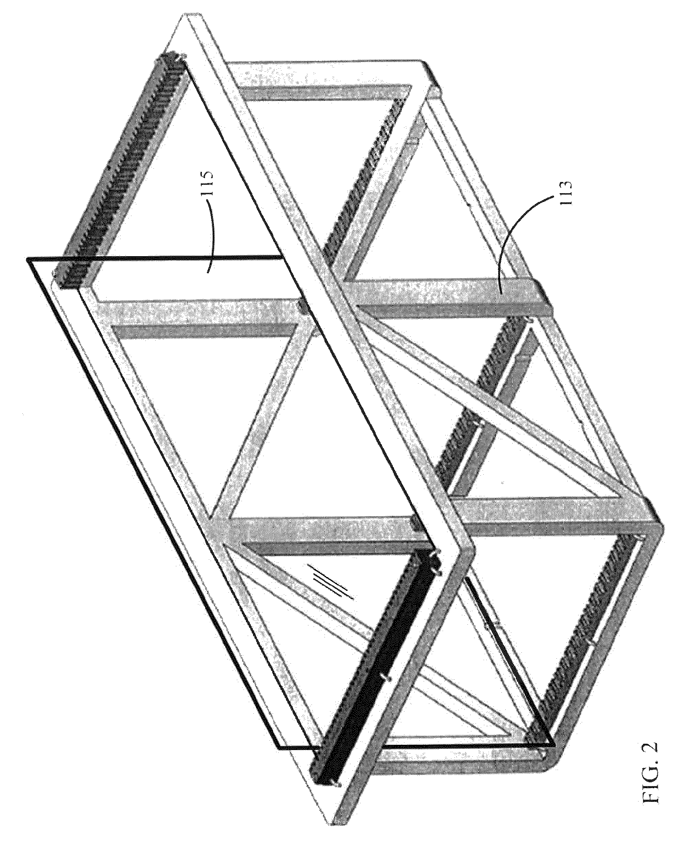

FIG. 2 shows an exemplary substrate support frame 113, configured for use with the exemplary embodiment of the thermal diffusion chamber 100 (of FIG. 1). In a preferred embodiment, the substrate support frame 113, is preferably formed from quartz, but may alternatively be formed from titanium or a titanium alloy, and accommodates a plurality of substrates 115 (one shown). In an alternate embodiment, the substrate support frame 113 is formed from titanium. In operation, the substrate support frame 113 is filled to capacity with substrates 115 and positioned within the process chamber 106. Within the process chamber 106, the substrate support frame 113, serves as a fixture for the substrates 115 during the diffusion process. Preferably the substrates 115 are rectangular in shape having a width of substantially 650 millimeters and a length of substantially 1650 millimeters, and are formed from glass, preferably soda-lime-silica glass.

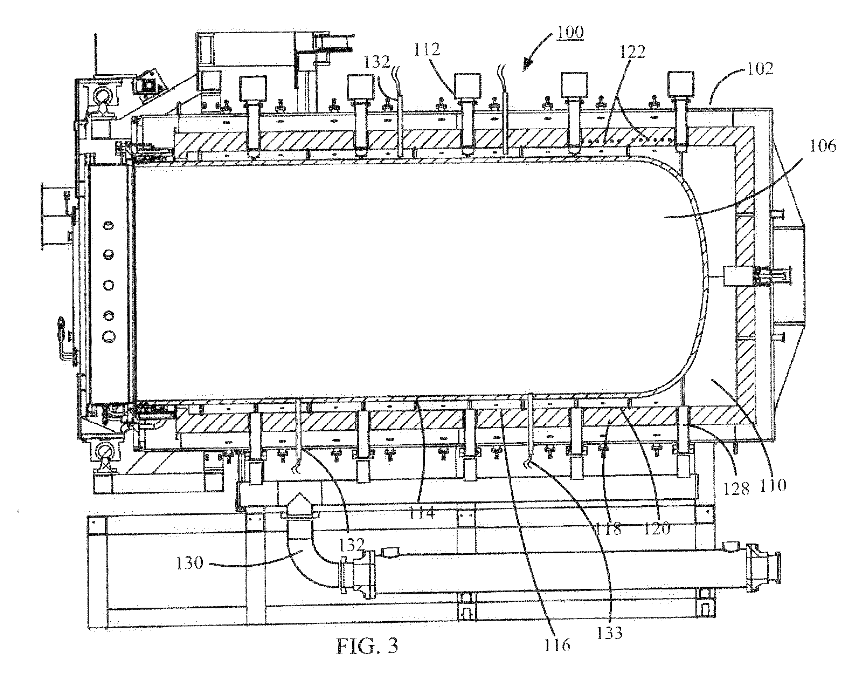

FIG. 3 shows an exemplary embodiment of the thermal diffusion chamber 100 includes the fluid inlet structure 112 in fluid communication with the thermal regulation cavity 110. Further shown by FIG. 3 is a plurality of supports 114 preferably positioned between the heat source module 108 and the process chamber 106.

In a preferred exemplary embodiment, the heat source module is formed from a plurality of heaters 116 (also referred to herein as a heat source), which in an exemplary embodiment consists of substantially a total of twenty two (22) heaters. Preferably, each heater provides a heater shell 118, heater insulation 120 adjacent the heater shell 118, and a plurality of heating elements 122. In an exemplary embodiment, the heating elements 122 are powered by electricity, and are preferably a coiled element. However it is noted that the term "heat source" is not limited to the disclosed plurality of heaters 116. The heat source 116 may be natural gas, super heated steam, geo-thermal energy, or any other source of energy to produce a desired temperature within the process chamber 106.

Returning back to FIG. 1, which shows the fluid inlet structure 112 further includes an inlet conduit 124 secured to an inlet manifold 126. Preferably, the inlet manifold 126 delivers air to the air inlet structures 112 for distribution over the process chamber 106, as depicted in FIG. 3.

FIG. 3 further shows the exemplary thermal diffusion chamber 100 includes a purge conduit 128 in fluidic communication with the thermal regulation cavity 110 and secured to an outlet manifold 130, the outlet manifold 130 selectively providing an internal pressure less than atmospheric pressure to draw air through the fluid inlet structure 112, around the process chamber 106, and out the purge conduit 128.

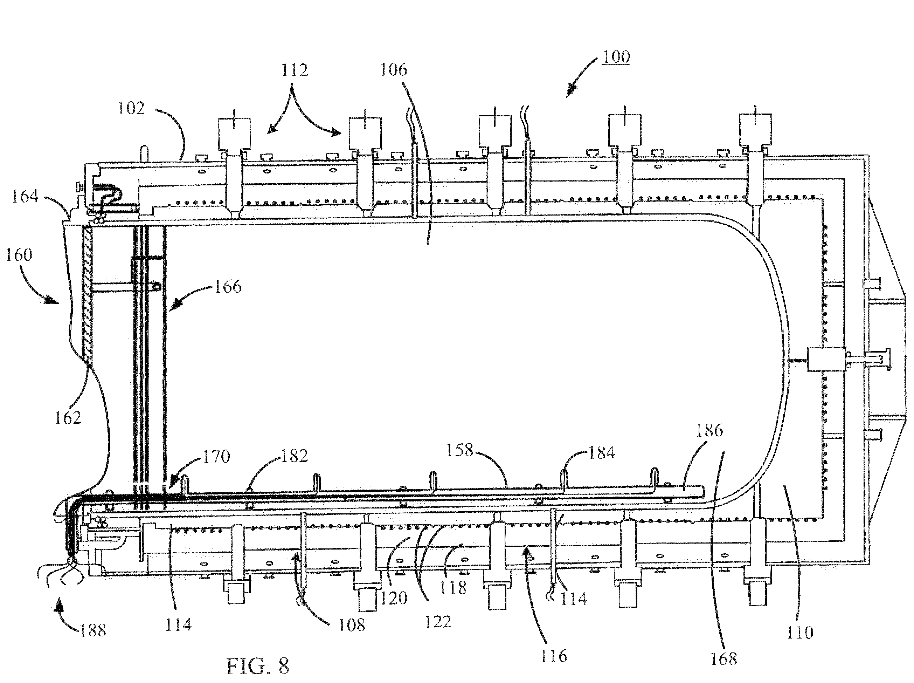

Also shown by FIG. 3, is a plurality of external thermal sensors 132 in contacting adjacency with the process chamber 106, extending through corresponding heaters 116, and presenting electrical lead lines 133 for connection from the outside of the containment chamber 102. In a preferred mode of operation of the exemplary thermal diffusion chamber 100, fluid flow is suspended, i.e., the fluid flow undergoes fluid flow modulation, to provide a more accurate reading of the external temperature of the process chamber 106. Information collected from the plurality of external thermal sensors 132 is used to cross check information collected by an internal thermal sensor assembly 158 of FIG. 8. Preferably the information collected by the internal thermal sensors is used to determine which air inlet structures 112 should undergo a restriction of fluid flow, and which should be adjusted for maximum fluid flow.

By adjusting the fluid flow through the plurality of air inlet structures 112, a more uniform cool down of the process chamber 106 may be attained. Further, in an alternate preferred mode of operation of the exemplary thermal diffusion chamber 100, the internal thermal sensor assembly 158, with additional input from the plurality of external thermal sensors 132, provides information for regulating an amount of power supplied to the heating elements 122 during a heat up cycle of the process chamber 106. That is, during a heat up cycle of the process chamber 106, power is being supplied to each of the plurality of heater 116. By modulating the power supplied to each of the plurality of heaters 116, a more uniform heat up of the process chamber 106 may be attained.

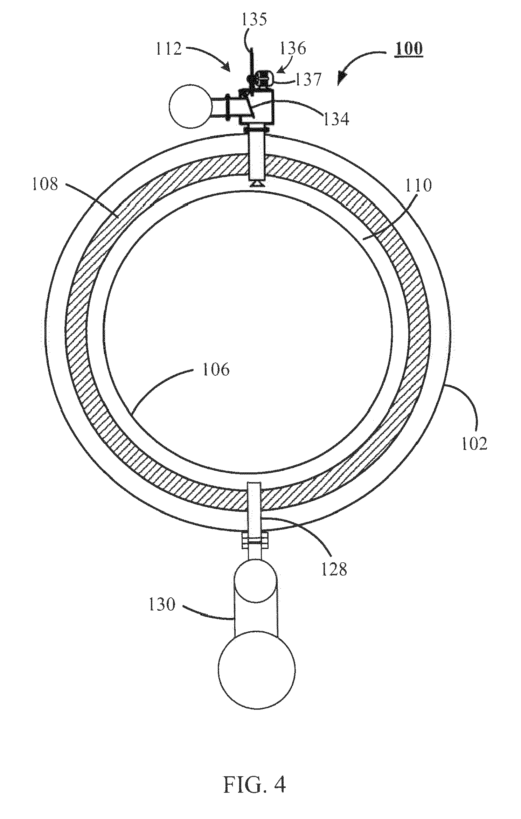

FIG. 4 depicts the fluid inlet structure 112 includes a valve 134, which mitigates the flow of fluid from the thermal regulation cavity 110 through the fluid inlet structure 112 and external to the containment chamber 102. FIG. 4 further shows the fluid inlet structure 112 includes a flow adjustment structure 136, which preferably includes a positioning shaft 135 controlled by a motor 137. In response to a rotation of the motor 137, the positioning shaft 135 interacts with the valve 134 to control fluid flow from the exterior of the containment chamber 102 past the valve 134 and into the thermal regulation cavity 110.

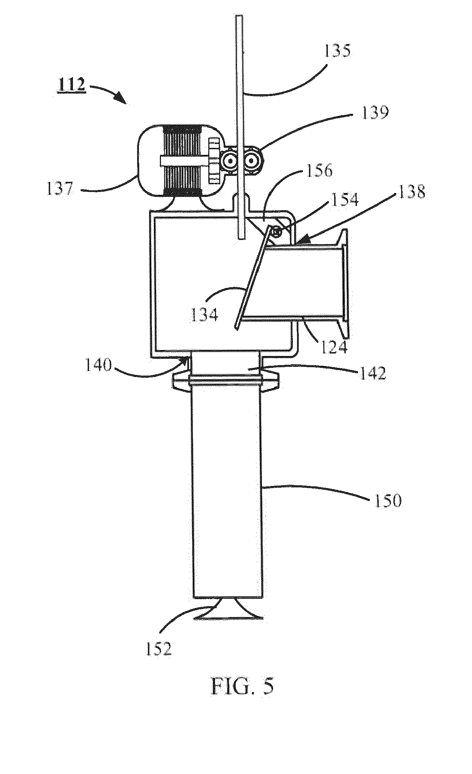

FIG. 5 provides a more detailed view of the fluid inlet structure 112. In a preferred embodiment, the fluid inlet structure 112 further provides an intake port 138 supporting the inlet conduit 124, which is in contacting adjacency with the valve 134. Preferably, the fluid inlet structure 112 further provides an exhaust port 140 that supports an outlet conduit 142 that is in fluidic communication with the thermal regulation cavity 110. During an operation of the fluid inlet structure 112, a pair of pinch rollers 139 of the motor 137 act upon the positioning shaft 135 to change a position of the positioning shaft 135 relative to the valve 134.

As shown by FIG. 5, in a preferred embodiment in addition to providing the exhaust port 140 supporting the outlet conduit 142, the fluid inlet structure 112 provides an extension conduit 150 having a proximal end and a distal end, the proximal end in contacting adjacency with and secured to the outlet conduit 142, the extension conduit 150 is provided to conduct fluid originating from the containment chamber 102 to the thermal regulation cavity 110 of FIG. 4. The distal end of the extension conduit 150 is preferably fashioned with a diffusion member 152 affixed thereon, wherein the diffusion member 152 is configured to preclude fluid originating external the containment chamber 102 from being applied to the process chamber 106 of FIG. 4 in a stream normal to the exterior of the process chamber 106.

FIG. 5 further shows the fluid inlet structure 112 further provides a pivot pin 154 disposed between the valve 134 and a pivot support 156. The pivot support 156 is secured adjacent the inlet conduit 124. The pivot pin 154, in combination with the flow adjustment structure 136, promotes a controlled, predetermined, and adjustable displacement of the valve 134 from contacting adjacency with the inlet conduit 124 when fluid is drawn into the thermal regulation cavity 110. The pivot pin 154 further promotes the closing of the valve 134 adjacent the inlet conduit 124 when the flow of fluid originating external the containment chamber 102 is stopped. In other words, a closed valve 134 deters passage of fluid from the thermal regulation chamber 110 to external the containment chamber 102 when fluid is not being drawn into the thermal regulation cavity 110.

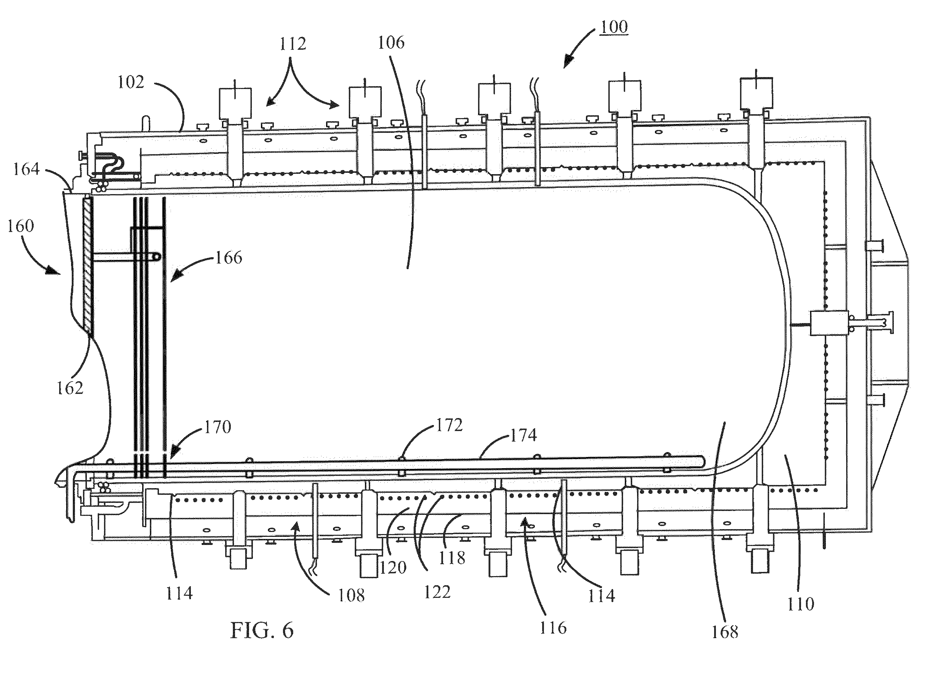

FIG. 6 shows that an exemplary embodiment of the thermal diffusion chamber 100 includes the fluid inlet structure 112 in fluid communication with the thermal regulation cavity 110. Further shown by FIG. 6 is a chamber door 160. Preferably, the chamber door 160 includes a face plate 162 secured to a main body portion 164, and a primary thermal dispersion assembly 166 secured to the face plate 162. With the exception of a bottom portion, the primary thermal dispersion assembly 166 is aligned in close proximity to an inner surface of a sealed process chamber 168, also referred to herein as process chamber 168. The sealed process chamber 168 is preferably formed when the chamber door 160 is secured in sealing contact with the process chamber 106.

In the exemplary embodiment of FIG. 6, a secondary thermal dispersion assembly 170 is aligned with the primary thermal dispersion assembly 166 and preferably communicates with a wall of the inner surface of the sealed process chamber 168. In conjunction with a plurality of support members 172, the secondary thermal dispersion assembly 170 confines and supports a closed loop heat exchanger 174 adjacent the wall of the sealed process chamber 168. The closed loop heat exchanger 174 provides a means for circulation of a fluid through the interior of the sealed process chamber 168, to facilitate a cool down of the interior of the sealed process chamber 168 during a process cycle of the thermal diffusion chamber 100.

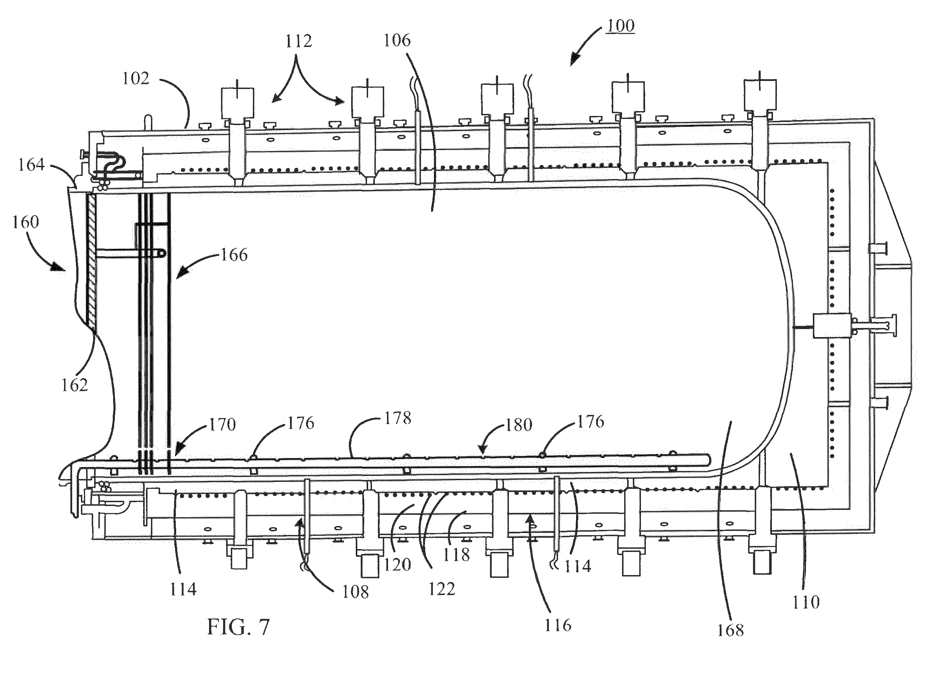

FIG. 7 shows that an alternate exemplary embodiment of the thermal diffusion chamber 100 includes the fluid inlet structure 112 in fluid communication with the thermal regulation cavity 110. Further shown by FIG. 7 is the chamber door 160, which preferably includes the face plate 162 secured to the main body portion 164, and the primary thermal dispersion assembly 166 secured to the face plate 162. With the exception of the bottom portion, the primary thermal dispersion assembly 166 is aligned in close proximity to the inner surface of the sealed process chamber 168.

In the alternate exemplary embodiment of FIG. 7, preferably, the secondary thermal dispersion assembly 170 is aligned with the primary thermal dispersion assembly 166 and rests on the bottom of the inner surface of the sealed process chamber 168. In conjunction with a plurality of support members 176, the secondary thermal dispersion assembly 170 confines and supports an open loop heat exchanger 178 adjacent the bottom of the sealed process chamber 168. The open loop heat exchanger 178 provides a plurality of supply ports 180 through which fluid may be introduced into the sealed process chamber 168 during a process cycle of the thermal diffusion chamber 100 to facilitate a cool down of the sealed process chamber 168.

FIG. 8 shows that an alternative exemplary embodiment of the thermal diffusion chamber 100 includes the fluid inlet structure 112 in fluid communication with the thermal regulation cavity 110. Further shown by FIG. 8 is the chamber door 160, which preferably includes the face plate 162 secured to the main body portion 164, and the primary thermal dispersion assembly 166 secured to the face plate 162. With the exception of the bottom portion, the primary thermal dispersion assembly 166 is aligned in close proximity to the inner surface of the sealed process chamber 168.

In the alternative exemplary embodiment of FIG. 8, the secondary thermal dispersion assembly 170 is aligned with the primary thermal dispersion assembly 166 and rests on the bottom of the inner surface of the sealed process chamber 168. In conjunction with a plurality of support members 182, the secondary thermal dispersion assembly 170 confines and supports the thermal sensor assembly 158 adjacent the bottom of the sealed process chamber 168. Preferably, the thermal sensor assembly 158 provides a plurality of thermocouples 184 disposed along a length of the sealed process chamber 168. The plurality of thermocouples 184, are responsive to a change in temperature of the interior of the sealed process chamber 168. Preferably, the thermal sensor assembly 158 further includes a sensor conduit 186 extending from an opening of the sealed process chamber 168 through at least a mid portion of the sealed process chamber 168. The sensor conduit 186 shields the plurality of thermocouples 184 from exposure to an internal environment of the sealed process chamber 168.

FIG. 8 further shows that the thermal sensor assembly 158 preferably further includes a plurality of signal lines 188 connected to and corresponding with each of the plurality of thermocouples 184. Each signal line 188 conveys a signal to the exterior of the sealed process chamber 168 in response to the change in temperature of the interior of the sealed process chamber 168.

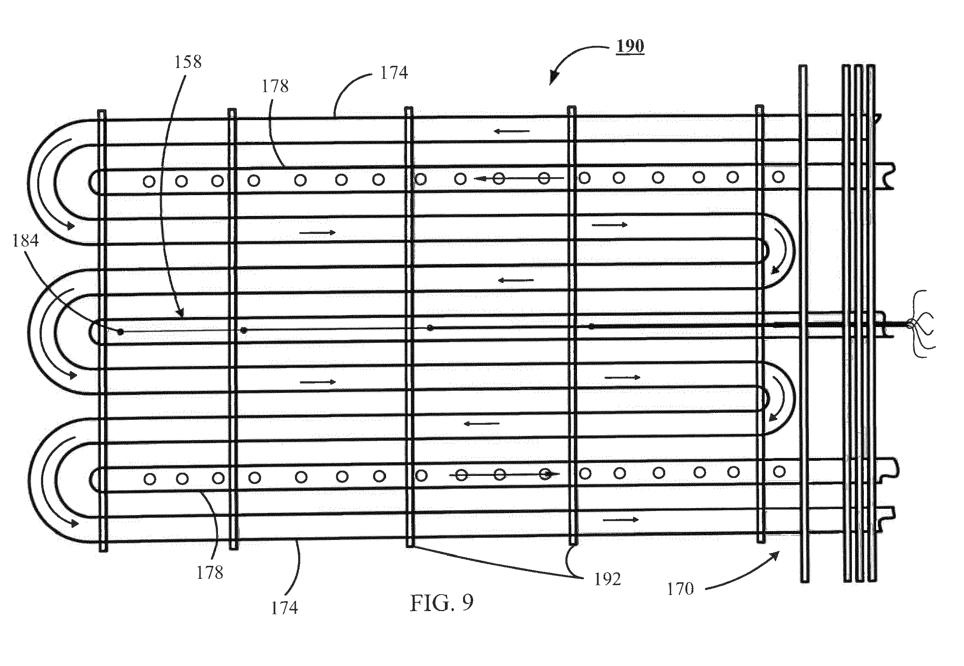

As shown in a preferred embodiment by FIG. 9, a combined heat exchange assembly 190 includes each: the closed loop heat exchanger 174 of FIG. 6; the open loop heat exchanger 178 of FIG. 7; and the thermal sensor assembly 158 of FIG. 8. The closed loop heat exchanger 174, the open loop heat exchanger 178, and the thermal sensor assembly 158 are each supported by a plurality of heat exchanger supports 192, and attached to and confined by the secondary thermal dispersion assembly 170.

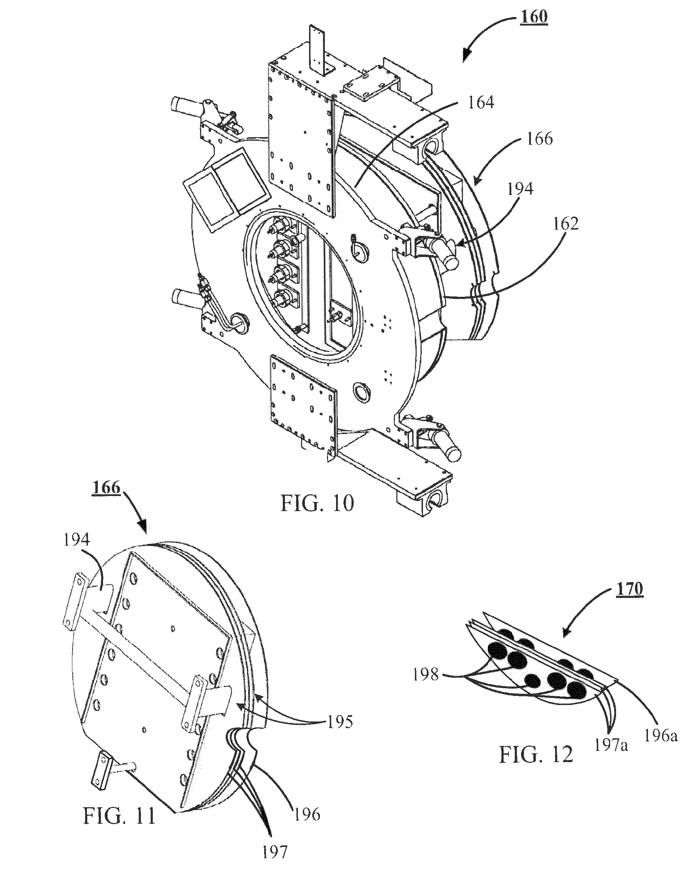

FIG. 10 provides a more detailed depiction of the chamber door 160. Preferably, the chamber door 160 includes a face plate 162 secured to the main body portion 164, and a lamp support 194 secured to the face plate 162. As shown by FIG. 10, the chamber door 160 further includes the primary thermal dispersion assembly 166, while the lamp support 194 provides a plurality of alignment notches 195 (shown by FIG. 11) upon which the thermal dispersion assembly 166 is aligned and rests during operational modes of the thermal diffusion chamber 100 of FIG. 8.

FIG. 11 further shows the primary thermal dispersion assembly 166 includes at least a diffusion plate 196 adjacent a plurality of radiation reflection plates 197. The diffusion plate 195 and a plurality of radiation reflection plates 197 are preferably held in alignment by the lamp support 194. In a preferred exemplary embodiment, the main body portion 164, the face plate 162, and the thermal dispersion assembly 166 are preferably formed from quartz, but may alternatively be formed from titanium or a titanium alloy.

FIG. 12 shows the secondary thermal dispersion assembly 170 provides a plurality of access ports 198, which are used to align, support, and confine each closed loop heat exchanger 174, the open loop heat exchanger 178, and the thermal sensor assembly 158 of FIG. 8. Preferably, the secondary thermal dispersion assembly 170 includes at least a diffusion plate 196 adj acent a plurality of radiation reflection plates 197a, which in a preferred embodiment are formed from quartz, but may alternatively be formed from titanium or a titanium alloy.

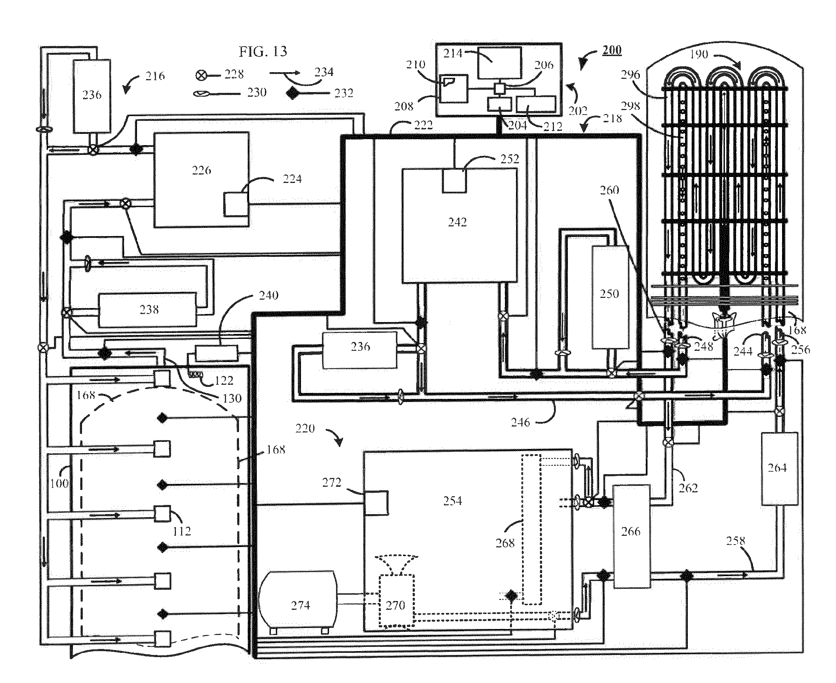

FIG. 13 illustrates a schematic of a heat exchange system 200 for use in cooling down an interior and an exterior of the sealed thermal chamber 168 during a process cycle of the thermal diffusion chamber 100. In a preferred embodiment, the heat exchange system 200 includes a control system 202 (also referred to herein as controller 202) communicating with each a first fluid handling system 216, a second fluid handling system 218, and third fluid handling system 220. Preferably, the control system 202 includes at least a control signal buss 222 communicating with at least the first, second, and third fluid handling systems (216, 218, 220), and a controller 202.

In a preferred embodiment, the controller 202 includes at least an input/output module 204 communicating with the control signal buss 222, a processor 206 communicating with the input/output module 204, a memory 208 storing control logic 210 and communicating with the processor 206, an input device 212 communicating with the processor 206 and a display 214 communicating with the processor 206.

During a preferred operation of the thermal chamber 100, upon receipt by the input/output module 204 of a measured temperature value of a first fluid flowing around the exterior of the sealed process chamber 168, the input/output module 204 provides said measured temperature value of the first fluid flowing around the exterior of the sealed process chamber 168 to the processor 206. The processor 206 accesses the stored control logic 210 and determines a control signal based on the measured temperature value of the first fluid flowing around the exterior of the sealed process chamber 168. The processor 206 transmits the control signal to the input/output module 204, the input/output module 204 advances the control signal by way of the control signal buss 222 to the first fluid handling system 216.

Preferably, the processor 206 further determines an in use flow capacity percentage of fluid flowing through the first fluid handling system 216 based on data received from a flow usage monitoring device 224 communicating with a fluid transfer device 226 of the first fluid handling system 216. The processor 206 still further preferably provides the in use flow capacity percentage of the first fluid transfer device 226 and the measured temperature value of the first fluid flowing around the exterior of the sealed process chamber 168 to the display 214.

The schematic of FIG. 13 shows that the heat exchange system 200 preferably utilizes a plurality of control valves 228, responsive to control signals generated by the processor 206 and provided to each of the plurality of control valves 228 by the control signal buss 222 to control the flow of fluids through each the first, second, and third fluid handling systems (216, 218, 220). FIG. 13 further shows that the heat exchange system 200 preferably utilizes a plurality of check valves 230 to control backflow of the flow of fluids through each the first, second, and third fluid handling systems (216, 218, 220), and a plurality of thermal sensors 232 to provide temperature measurement values to the processor 206 upon which the processor 206 bases the determination of a plurality of control signals to be transmitted to each corresponding control valve of the plurality of control valves 228.

FIG. 13 still further provides a flow direction symbol 234, which reveals the direction of flow of fluids through each corresponding the first, second, and third fluid handling systems (216, 218, 220), and that each of the plurality of thermal sensors 232 along with each of the plurality of control valves 228 communicate with the control signal buss 222. In a preferred embodiment, the first fluid handling system 216 includes at least the first fluid transfer device 226 in fluid communication with at least one fluid inlet structure 112. The at least one fluid inlet structure 112 is preferably in fluidic communication with an exterior of the sealed process chamber 168, and the at least one fluid inlet structure 112 includes at least: the flow adjustment structure 137 (of FIG. 5) to control the flow of the first fluid around the exterior of the sealed process chamber 168; and a fluid return conduit 130 in fluid communication with each the exterior of the sealed process chamber 168 and the first fluid transfer device 226, the fluid return conduit 130 returning the first fluid flowing around the sealed process chamber 168 to the first fluid transfer device 226.

As shown by FIG. 13, the first fluid handling system 216 preferably includes a first thermal sensor of the plurality of fluid sensors 232 communicating with each the returned first fluid and the control system 202, the first thermal sensor measures a temperature value of the returned first fluid and provides that value to the control system 202. Upon receipt of the measured temperature value by the control system 202, the processor 206 of the control system 202 compares the measured temperature value to a predetermined temperature value and sends a control signal to a first control valve of the plurality of control valves 228 disposed between the fluid return conduit 130 and the first fluid transfer device 226. In response to the control signal, the first control valve modulates flow of the returned first fluid from the exterior of the sealed process chamber 168 to the first fluid transfer device 226.

Further shown by FIG. 13, the first fluid handling system 216 preferably further includes an in line fluid heater 236, such as a SureHeat MAX® manufactured by OSRAM Sylvania of Danvers Main, USA. Preferably the in line fluid heater 236 is plumbed into the first fluid handling system 216 between the fluid transfer device 226 and the plurality of fluid inlet boxes 112. The in line fluid heater 236 may be selectively included in the fluid path of the first fluid through activation of a second control valve in response to a control signal provided by the control signal buss 222 from the processor 206 based on a temperature measurement value provided by a second thermal sensor measuring the first fluid exiting the fluid transfer device 226. The in line fluid heater 236 is preferably used when the out flow temperature of the first fluid departing the fluid transfer device 226 is less than a desired inlet temperature of the fluid inlet structure 112.

Additionally, the first fluid handling system 216 preferably further includes a heat exchanger 238, external to and plumbed into the first fluid handling system 216 between the thermal diffusion chamber 100 and the fluid transfer device 226. The heat exchanger 238 may be selectively included in the fluid path of the first fluid through activation of a third control valve in response to a control signal provided by the control signal buss 222 from the processor 206 based on a temperature measurement value provided by a third thermal sensor measuring the first fluid exiting the thermal diffusion chamber 100. Preferably, the heat exchanger 238 is utilized to safeguard the fluid transfer device 226 from experiencing a thermal condition that exceeds its operating parameters.

To provide data regarding an in use thermal capacity of each of the plurality of heat sources 116 (of FIG. 8), the first fluid handling system 216 preferably further includes an energy usage monitoring device 240 communicating with each the heat elements 130 of the plurality of heat sources 116 and the control system 202. The energy monitoring device 240 is preferably used to safeguard against thermal runaway of each of the plurality of heat sources 116. That is, when any of the plurality of heat sources 116 exceeds a preferred, predetermined usage percentage, the processor 206 issued a command to an energy source control unit instructing the energy source control unit to stop the supply of energy to the out of operating range heat source 116. The processor further preferably provides the in use thermal capacity status of each of the plurality of heat sources 116 to the display 214 for presentation by the display 214.

In the preferred embodiment, shown by FIG. 13, the third fluid handling system 220 preferably includes at least a closed system fluid transfer device 242 in fluid communication with at least one fluid distribution conduit 244. The at least one fluid distribution conduit 244 is preferably in fluidic communication with an interior of the sealed process chamber 168. Preferably, a feed conduit 246 is disposed between the second fluid transfer device 242 and the at least one fluid distribution conduit 244. The feed conduit 246 preferably communicates the second fluid from the second fluid transfer device 242 to the at least one fluid distribution conduit 244.

Also preferably provided by the second fluid handling system 218 is a check valve disposed between the feed conduit 246 and the at least one fluid distribution conduit 244, the check valve mitigating a back flow from the interior of the sealed process chamber 168 to the second fluid transfer device 242. Additionally, an interior fluid control valve is preferably plumbed between the second fluid transfer device 242 and the at least one fluid distribution conduit 244, to control a flow of the second fluid into the interior of the sealed process chamber 168. The preferred embodiment also provides a fluid collection conduit 248 in fluid communication with the interior of the sealed process chamber 168 and the second fluid transfer device 242. The fluid collection conduit 248 returns the second fluid flowing into the interior of the sealed process chamber 168 to the second fluid transfer device 242.

Preferably, a fourth thermal sensor communicating with the returned second fluid and the control system 202 is provided by the second fluid handling system 218. The fourth thermal sensor preferably measures a temperature value of the returned second fluid and provides said measured temperature value to the control system 202. Upon receipt of the measured temperature value by the control system 202, the control system 202 compares the measured temperature value to a predetermined temperature value and sends an interior fluid control valve signal to the interior fluid control valve to modulate flow of the returned second fluid from the second fluid transfer device 242 in response to the interior fluid control valve signal.

Further shown by FIG. 13, the second fluid handling system 218 preferably further includes an in line fluid heater 236, such as a SureHeat MAX® manufactured by OSRAM Sylvania of Danvers Main, USA. Preferably the in line heater 236 is plumbed into the second fluid handling system 218 between the fluid transfer device 242 and the feed conduit 246. The in line fluid heater 236 may be selectively included in the fluid path of the second fluid through activation of a fourth control valve in response to a control signal provided by the control signal buss 222 from the processor 206. The control signal is preferably based on a temperature measurement value provided by a fifth thermal sensor measuring the second fluid exiting the fluid transfer device 242. The in line fluid heater 236 is preferably used when the out flow temperature of the second fluid departing the fluid transfer device 242 is less than a desired inlet temperature of the at least one fluid distribution conduit 244.

Additionally, the second fluid handling system 218 preferably further includes a heat exchanger 250, external to and plumbed into the second fluid handling system 218 between the fluid collection conduit 248 and the second fluid transfer device 242. The heat exchanger 250 may be selectively included in the fluid path of the second fluid through activation of a fifth control valve in response to a control signal provided by the control signal buss 222 from the processor 206 based on a temperature measurement value provided by a sixth thermal sensor measuring the second fluid entering the fluid collection conduit 248.

Preferably, the heat exchanger 250 is utilized to safeguard the fluid transfer device 242 from experiencing a thermal condition that exceeds its operating parameters. Further, to provide data regarding an in use percentage of the fluid transfer device 242, a flow usage monitoring device 252 is preferably used to safeguard against exceeding the operating capabilities of the fluid transfer device 242.

In the preferred embodiment, shown by FIG. 13, the third fluid handling system 220 is preferably a closed loop fluid handling system 220. That is, the third fluid is isolated from all environments external to the closed loop fluid handling system 220. The closed loop fluid handling system 220 preferably includes at least a closed loop fluid transfer device 254 in fluid communication with at least one fluid distribution conduit 256. The at least one fluid distribution conduit 256 is preferably adjacent an interior of the sealed process chamber 168. Preferably, a feed conduit 258 is disposed between the closed loop fluid transfer device 254 and the at least one fluid distribution conduit 256. The feed conduit 258 preferably communicates the isolated third fluid from the closed loop fluid transfer device 254 to the at least one fluid distribution conduit 244.

Also preferably provided by the closed loop fluid handling system 220 is a check valve disposed between the feed conduit 258 and the at least one fluid distribution conduit 256, the check valve mitigating a back flow from the at least one fluid distribution conduit 256 to the closed loop fluid transfer device 254. Additionally, a sixth fluid control valve is preferably plumbed between the closed loop fluid transfer device 254 and the at least one fluid distribution conduit 256, to control a flow of the isolated third fluid into the at least one fluid distribution conduit 256. The preferred embodiment also provides a fluid collection conduit 260 in fluid communication with a return conduit 262 and the closed loop fluid transfer device 254. The fluid collection conduit 260 returns the isolated third fluid flowing into the at least one fluid distribution conduit 256.

Preferably, a seventh thermal sensor that communicates with the returned isolated third fluid and the control system 202 is provided by the second fluid handling system 220. The seventh thermal sensor preferably measures a temperature value of the returned isolated third fluid and provides said measured temperature value to the control system 202. Upon receipt of the measured temperature value by the control system 202, the control system 202 compares the measured temperature value to a predetermined temperature value and sends a fluid control valve signal to the fluid control valve, preferably plumbed in between the fluid collection conduit 260 and the return conduit 262. The fluid control valve preferably functions to modulate flow of the returned isolated third fluid from the return conduit 262 to the closed loop fluid transfer device 254 in response to the fluid control valve signal.

Further shown by FIG. 13, the closed loop fluid handling system 220 preferably further includes an in-line fluid heater 264, such as a SureHeat MAX® manufactured by OSRAM Sylvania of Danvers Main, USA. Preferably the in-line fluid heater 264 is plumbed into the closed loop fluid handling system 220 between the feed conduit 258 and the at least one fluid distribution conduit 256. The in line fluid heater 236 may be selectively engaged or disengaged during an operation mode of the closed loop fluid handling system 220 in response to a control signal. The control signal is preferably based on a temperature measurement value provided by an eighth thermal sensor measuring the isolated third fluid exiting an external gas to gas heat exchanger 266. The external gas to gas heat exchanger 266 is preferably plumbed into the closed loop fluid handling system 220 between the feed conduit 258 and the closed loop fluid transfer device 254. The in line fluid heater 264 is preferably used when the out flow temperature of the isolated third fluid is departing the external gas to gas heat exchanger 266 is less than a desired inlet temperature if the at least one fluid distribution conduit 256. Preferably, the external gas to gas heat exchanger 266 extracts heat from the isolated third fluid provided by the return conduit 262, and transfers the extracted heat to the isolated third fluid provided by the closed loop fluid transfer device 254.

Additionally, the closed loop fluid handling system 220 preferably further includes a heat exchanger 268, internal to and plumbed within the closed loop fluid transfer device 254. The heat exchanger 268, may be selectively included in the fluid path of the isolated third fluid through activation of a sixth control valve in response to a control signal provided by the control signal buss 222 from the processor 206 based on a temperature measurement value provided by a ninth thermal sensor measuring the isolated third fluid exiting the external gas to gas heat exchanger 266.

Preferably, the heat exchanger 268 is utilized to safeguard a fluid advancement device 270 housed within the closed loop fluid transfer device 254, from experiencing a thermal condition that exceeds the operating parameters of the fluid advancement device 270. Further, to provide data regarding an in use percentage of the closed loop fluid transfer device 254, a flow usage monitoring device 272 is preferably used to safeguard against exceeding the operating capabilities of the fluid advancement device 270, while being operated by a drive system 274, connected to the fluid advancement device 270. In a preferred embodiment the isolated third fluid is held at a pressure below atmospheric pressure, while the fluid is at ambient temperature, to allow for thermal expansion of the isolated third fluid when the isolated third fluid is absorbing thermal energy from the interior of the sealed process chamber 168.

It is noted that each the first fluid, the second fluid, and the isolated third fluid may be any of a number of fluids including, but not limited to air, water, nitrogen, helium, propylene glycol, ethylene glycol, or any other heat transfer sympathetic fluid.

It is further noted that FIG. 13 shows that the preferred embodiment heat exchange system 200 includes the exemplary combined heat exchange assembly 190, which preferably includes each: the closed loop heat exchanger 174 of FIG. 6; the open loop heat exchanger 178 of FIG. 7; and the thermal sensor assembly 158 of FIG. 8.

A person skilled in the art will understand that alternate embodiments are inherently presented by FIG. 13. A number of these include, but are not limited to, a fluid handling system such as 216 in fluidic communication with the exterior of the sealed process chamber 168, combined with a closed loop heat exchange system in fluidic communication with the interior of the sealed process chamber 168. Wherein the control system 202 communicates with each the fluid handling system 216 and the closed loop heat exchange system, and sets a flow rate of each the fluid flowing around an exterior of the sealed process chamber 168, fluid flowing through the closed loop heat exchange system in response to the measured internal temperature of the sealed process chamber 168.

In the present alternate embodiment, the closed loop heat exchange system preferably includes at least a fluid transfer device, such as the closed loop fluid transfer device 254 in fluid communication with at least one closed loop heat exchanger, such as the closed loop heat exchanger 174 of FIG. 6. In the present alternate embodiment, the exterior surface of the exemplary closed loop heat exchanger 174 is adjacent an interior surface of the sealed process chamber 168.

A second alternate embodiment includes at least a fluid handling system such as 216 in fluidic communication with the exterior of the sealed process chamber 168, combined with an open loop heat exchange system in fluidic communication with the interior of the sealed process chamber 168. The second alternate embodiment preferably further includes the control system 202, which communicates with each the fluid handling system 216 and the open loop heat exchange system, and sets a flow rate of each the fluid flowing around an exterior of the sealed process chamber 168, fluid flowing through the open loop heat exchange system and into the sealed process chamber 168 processing cavity in response to the measured internal temperature of the sealed process chamber.

In the present second alternate embodiment, the open loop heat exchange system preferably includes at least a fluid transfer device, such as the fluid transfer device 242 in fluid communication with at least one open loop heat exchanger, such as the open loop heat exchanger 178 of FIG. 7. In the present alternate embodiment, the exterior surface of the exemplary closed loop heat exchanger 174 is adjacent an interior surface of the sealed process chamber 168.

A third alternate embodiment includes at least a fluid handling system such as 216 in fluidic communication with the exterior of the sealed process chamber 168, combined with a closed loop heat exchange system, and an open loop heat exchange system, in which both the open loop and closed loop heat exchange systems are in fluidic communication with the interior of the sealed process chamber 168.

The third alternate embodiment preferably further includes the control system 202, which communicates with each the fluid handling system 216, the closed loop heat exchange system, and the open loop heat exchange system, and sets a flow rate of each the fluid flowing around an exterior of the sealed process chamber 168, and the fluid flowing through each the open loop and closed loop heat exchange systems, and into the sealed process chamber 168 processing cavity in response to the measured internal temperature of the sealed process chamber.

In the present third alternate embodiment, the open loop heat exchange system preferably includes at least a fluid transfer device, such as the fluid transfer device 242 in fluid communication with at least one open loop heat exchanger, such as the open loop heat exchanger 178 of FIG. 7. In the present alternate embodiment, the exterior surface of the exemplary closed loop heat exchanger 174 is adjacent an interior surface of the sealed process chamber 168. Further, in the third alternate embodiment, the closed loop heat exchange system preferably includes at least a fluid transfer device, such as the closed loop fluid transfer device 254 in fluid communication with at least one closed loop heat exchanger, such as the closed loop heat exchanger 174 of FIG. 6. In the present alternate embodiment, the exterior surface of the exemplary closed loop heat exchanger 174 is adjacent an interior surface of the sealed process chamber 168.

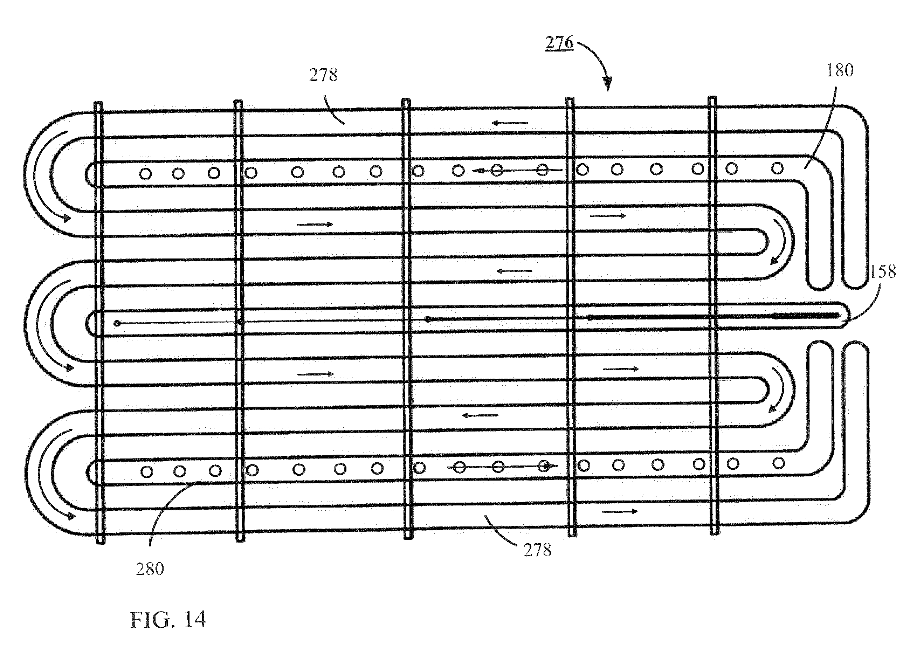

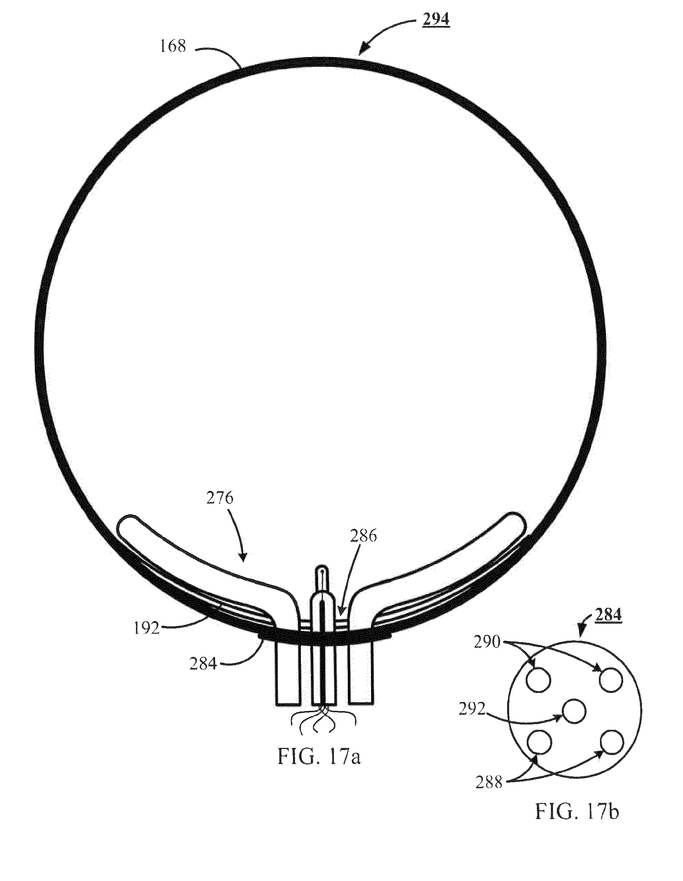

Turning to FIG. 14, shown therein is an alternate exemplary embodiment of a combined heat exchange assembly 276 that preferably includes each: a closed loop heat exchanger 278; an open loop heat exchanger 280; and the thermal sensor assembly 158 of FIG. 8. The closed loop heat exchanger 278, the open loop heat exchanger 280, and the thermal sensor assembly 158 are each supported by the plurality of heat exchanger supports 192, and attached to and confined by a bottom port support 284 of FIG. 17 attached adjacent an access port 286 of the sealed process chamber 168 of FIG. 17.

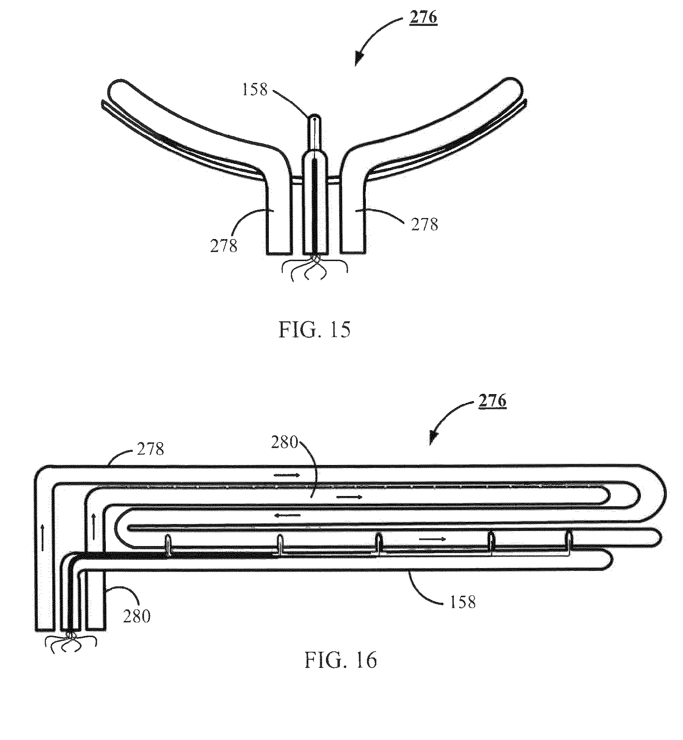

FIG. 15 shows a front view in elevation of the exemplary combined heat exchange assembly 276. Preferably the combined heat exchange assembly 276 includes at least the closed loop heat exchanger 278 adjacent the thermal sensor assembly, and each supported by the plurality of heat exchanger supports 192. FIG. 16 shows a right side view in elevation of the exemplary combined heat exchange assembly 276. Preferably the combined heat exchange assembly 276 includes at least the closed loop heat exchanger 278 adjacent each the open loop heat exchanger 280, and the thermal sensor assembly 158.

FIG. 17a shows a front view in elevation of the exemplary combined heat exchange assembly 276 mounted within the sealed process chamber 168 of a thermal diffusion system 294. The heat exchange assembly 276, preferably includes at least the closed loop heat exchanger 278 adjacent the thermal sensor assembly and each secures to the bottom port support 284, and protruding through the access port 286 of the sealed process chamber 168 of FIG. 17, and supported by the plurality of heat exchanger supports 192.

FIG. 17b shows a plan view of the bottom port support 284, to reveal: a pair of closed loop access ports 288, through which the closed loop heat exchanger 278 gains access to the interior of the sealed process chamber 168; a pair of open loop access ports 290, through which the open loop heat exchanger 280 gains access to the interior of the sealed process chamber 168; and a thermal sensor access port 292, through which the thermal sensor assembly 158 gains access to the interior of the sealed process chamber 168.

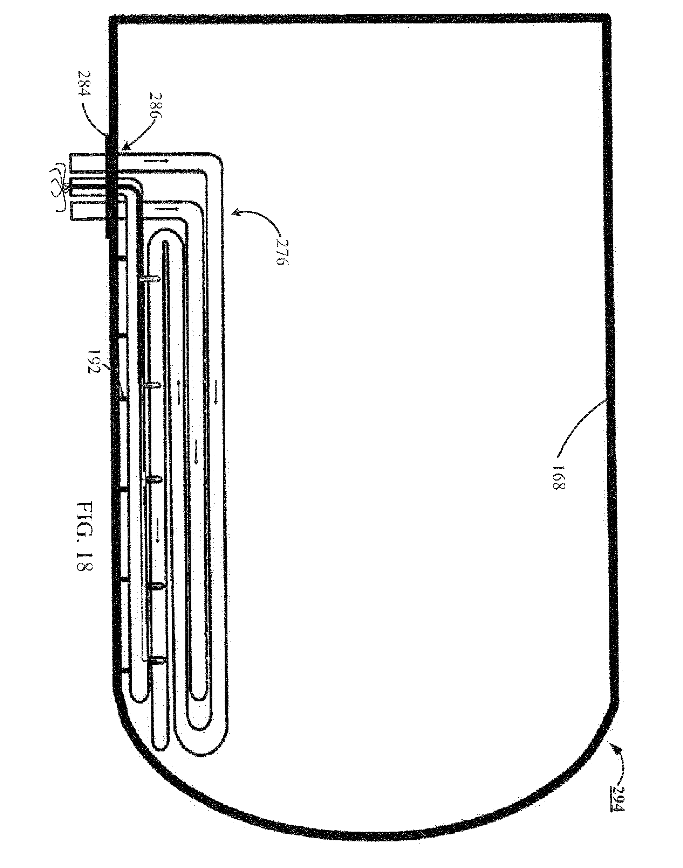

FIG. 18 shows a right side view in elevation of the exemplary diffusion chamber 294 that preferably includes the combined heat exchange assembly 276 adjacent the interior surface of the sealed process chamber 168. Preferably the combined heat exchange assembly 276 includes at least the closed loop heat exchanger 278 adjacent each the open loop heat exchanger 280, and the thermal sensor assembly 158. FIG. 18 further shows the combined heat exchange assembly 276 is supported by the plurality of heat exchanger supports 192, and secured to the bottom port support 284.

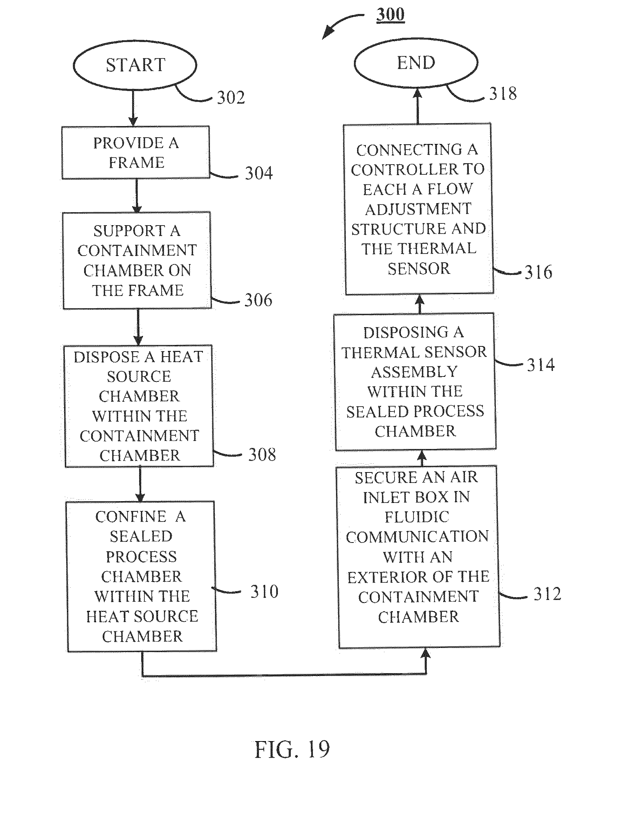

FIG. 19 provides an exemplary method of making a thermal chamber 300, which commences at start step 302 and continues with process step 304. At process step 304, a frame (such as 104) is provided. At process step 306, a containment chamber (such as 102) is supported and secured to the frame. At process step 308, a heat source module is disposed within and confined by the containment chamber. At process step 310, a sealed process chamber (such as 168) is confined within the heat source module. Preferably, the sealed process chamber includes at least an interior surface and an exterior surface.

A process step 312, a fluid inlet structure (such as 112) is preferably secured to the containment chamber in fluidic communication with the thermal regulation cavity. Preferably, the fluid inlet structure provides a valve (such as 134) that mitigates the flow of gasses from the thermal regulation cavity through the fluid inlet structure and to the atmosphere, and wherein the fluid inlet structure further includes a flow adjustment structure (such as 136) interacting with the valve to control fluid flow from the atmosphere past the valve and into thermal regulation cavity.

At process step 314, a thermal sensor assembly (such as 158) is disposed within the sealed process chamber. At process step 316, a controller (such as 204) is connected to each a flow adjustment structure (such as 136) and the thermal assembly, and the process concludes at end process step 318.

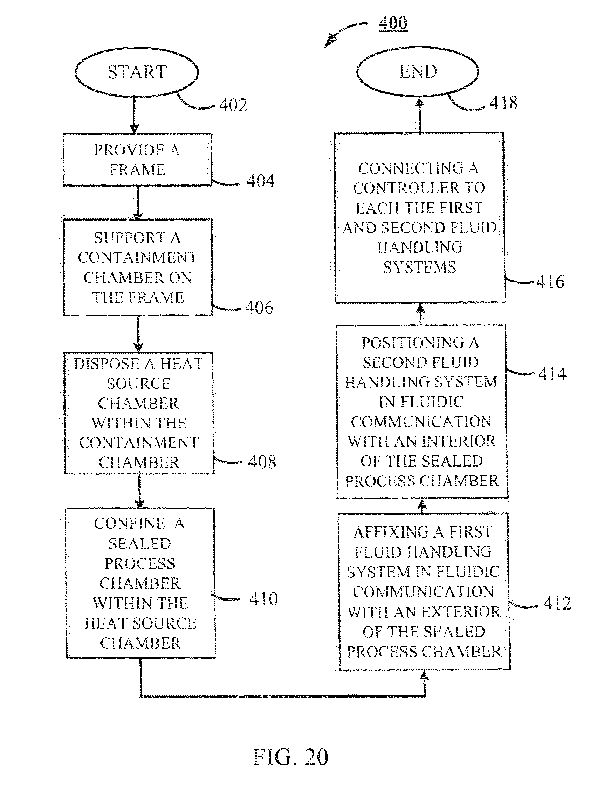

FIG. 20 provides an exemplary method of making a thermal chamber 400, which commences at start step 402 and continues with process step 404. At process step 404, a frame (such as 104) is provided. At process step 406, a containment chamber (such as 102) is supported and secured to the frame. At process step 408, a heat source module is disposed within and confined by the containment chamber. At process step 410, a sealed process chamber (such as 168) is confined within the heat source module. Preferably, the sealed process chamber includes at least an interior surface and an exterior surface.

A process step 412, a first fluid handling system (such as 216) is preferably secured to in fluidic communication with an exterior of the sealed process chamber. Preferably, the first fluid handling system provides a fluid inlet structure (such as 112), which in turn provides a valve (such as 134). The valve mitigates the flow of fluid from the thermal regulation cavity through the fluid inlet structure and external the containment chamber, and wherein the fluid inlet structure further includes a flow adjustment structure (such as 136) interacting with the valve to control fluid flow from external the containment chamber, past the valve and into thermal regulation cavity.

A process step 414, a second fluid handling system (such as 218, or 220) is preferably positioned in fluidic communication with an interior of the sealed process chamber. Preferably, the second fluid handling system provides means for transferring fluid into and out of the interior of the sealed process chamber during a thermal diffusion process cycle. At process step 416, a controller (such as 204) is connected to each the first and second fluid handling systems, and the process concludes at end process step 418.

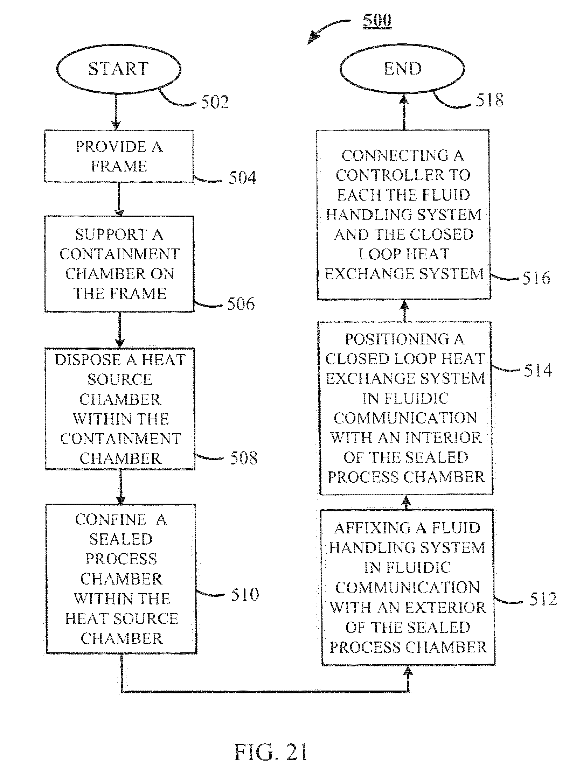

FIG. 21 provides an exemplary method of making a thermal chamber 500, which commences at start step 502 and continues with process step 504. At process step 504, a frame (such as 104) is provided. At process step 506, a containment chamber (such as 102) is supported and secured to the frame. At process step 508, a heat source module is disposed within and confined by the containment chamber. At process step 510, a sealed process chamber (such as 168) is confined within the heat source module. Preferably, the sealed process chamber includes at least an interior surface and an exterior surface.

At process step 512, a fluid handling system (such as 216) is preferably secured to in fluidic communication with an exterior of the sealed process chamber. Preferably, the first fluid handling system provides a fluid inlet structure (such as 112), which in turn provides a valve (such as 134). The valve mitigates the flow of fluid from the thermal regulation cavity through the fluid inlet structure and external the containment chamber, and wherein the fluid inlet structure further includes a flow adjustment structure (such as 136) interacting with the valve to control fluid flow from external the containment chamber, past the valve and into thermal regulation cavity.

At process step 514, a closed loop heat exchange system (such as 296 of FIG. 13) is preferably positioned in fluidic communication with an interior of the sealed process chamber. Preferably, the closed loop heat exchange system provides means for transferring fluid into and out of the interior of the sealed process chamber during a thermal diffusion process cycle, without exposing the transferred fluid to the internal environment of the sealed process chamber. At process step 516, a controller (such as 204) is connected to each the fluid handling system and the closed loop heat exchange system, and the process concludes at end process step 518.

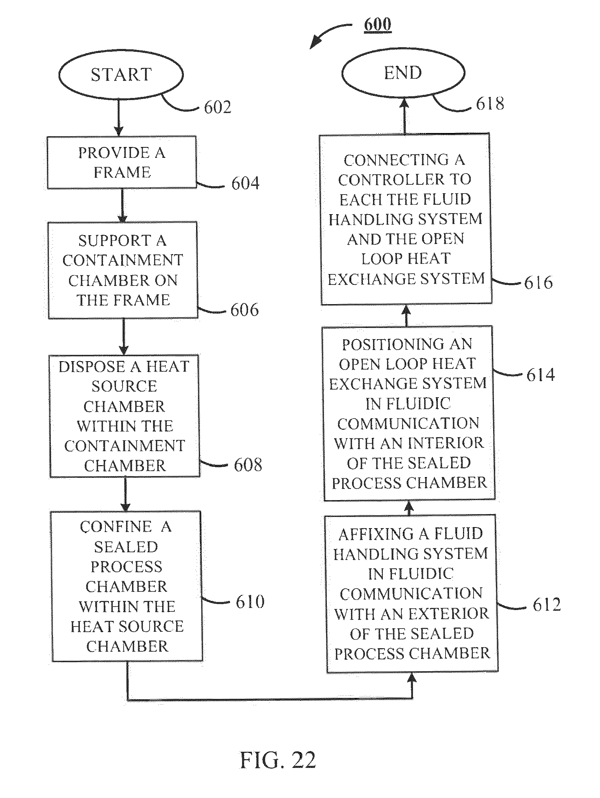

FIG. 22 provides an exemplary method of making a thermal chamber 600, which commences at start step 602 and continues with process step 604. At process step 604, a frame (such as 104) is provided. At process step 606, a containment chamber (such as 102) is supported and secured to the frame. At process step 608, a heat source module is disposed within and confined by the containment chamber. At process step 610, a sealed process chamber (such as 168) is confined within the heat source module. Preferably, the sealed process chamber includes at least an interior surface and an exterior surface.

At process step 612, a fluid handling system (such as 216) is preferably secured to in fluidic communication with an exterior of the sealed process chamber. Preferably, the first fluid handling system provides a fluid inlet structure (such as 112), which in turn provides a valve (such as 134). The valve mitigates the flow of fluid from the thermal regulation cavity through the fluid inlet structure and external the containment chamber, and wherein the fluid inlet structure further includes a flow adjustment structure (such as 136) interacting with the valve to control fluid flow from external the containment chamber, past the valve and into thermal regulation cavity.

At process step 614, an open loop heat exchange system (such as 298 of FIG. 13) is preferably positioned in fluidic communication with an interior of the sealed process chamber. Preferably, the loop heat exchange system provides means for transferring fluid into and out of the interior of the sealed process chamber during a thermal diffusion process cycle, by pulling the transferred fluid through the internal environment of the sealed process chamber. At process step 616, a controller (such as 204) is connected to each the fluid handling system and the open loop heat exchange system, and the process concludes at end process step 618.

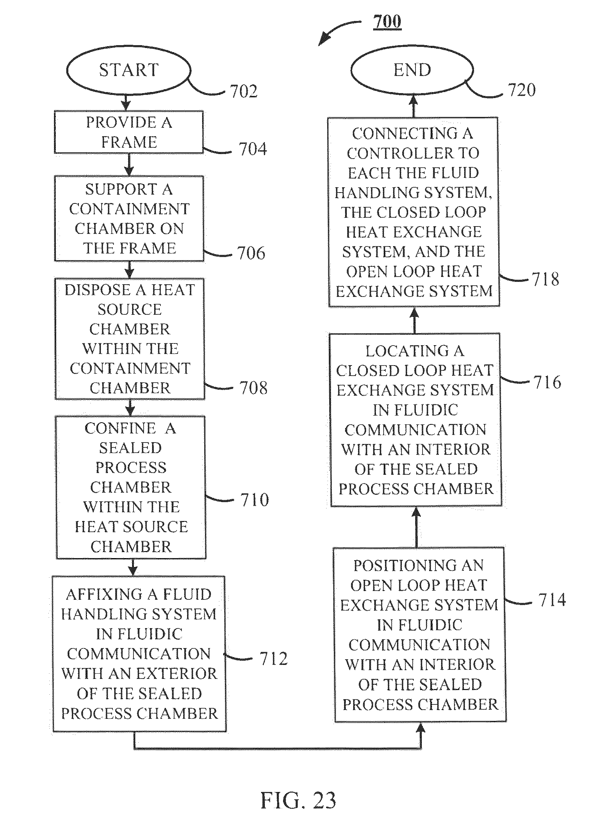

FIG. 23 provides an exemplary method of making a thermal chamber 700, which commences at start step 702 and continues with process step 704. At process step 704, a frame (such as 104) is provided. At process step 706, a containment chamber (such as 102) is supported and secured to the frame. At process step 708, a heat source module is disposed within and confined by the containment chamber. At process step 710, a sealed process chamber (such as 168) is confined within the heat source module. Preferably, the sealed process chamber includes at least an interior surface and an exterior surface.

At process step 712, a fluid handling system (such as 216) is preferably secured to in fluidic communication with an exterior of the sealed process chamber. Preferably, the first fluid handling system provides a fluid inlet structure (such as 112), which in turn provides a valve (such as 134). The valve mitigates the flow of fluid from the thermal regulation cavity through the fluid inlet structure and external the containment chamber, and wherein the fluid inlet structure further includes a flow adjustment structure (such as 136) interacting with the valve to control fluid flow from external the containment chamber, past the valve and into thermal regulation cavity.

At process step 714, an open loop heat exchange system (such as 298 of FIG. 13) is preferably positioned in fluidic communication with an interior of the sealed process chamber. Preferably, the loop heat exchange system provides means for transferring fluid into and out of the interior of the sealed process chamber during a thermal diffusion process cycle, by pulling the transferred fluid through the internal environment of the sealed process chamber.

At process step 716, a closed loop heat exchange system (such as 296 of FIG. 13) is preferably located in fluidic communication with an interior of the sealed process chamber. Preferably, the closed loop heat exchange system provides means for transferring fluid into and out of the interior of the sealed process chamber during a thermal diffusion process cycle, without exposing the transferred fluid to the internal environment of the sealed process chamber.

At process step 718, a controller (such as 204) is connected to each the fluid handling system and the open loop heat exchange system, and the process concludes at end process step 720.

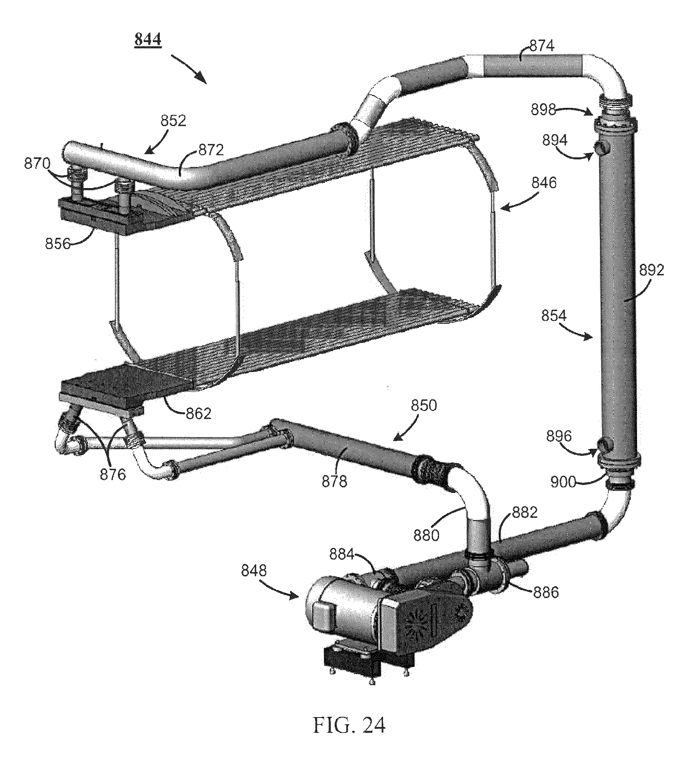

FIG. 24 displays an exemplary open loop heat exchange system 844 of the claimed subject matter, which preferably includes cooling tubes assembly 846 communicating with an air handling unit 848 (also referred to herein as a fluid handling unit 848) by way of an inlet conduit assembly 850 and an outlet conduit assembly 852. FIG. 24 further shows that the exemplary open loop heat exchange system 844 preferably includes a heat exchanger 854 disposed between the outlet conduit assembly 852 and the air handling unit 848.

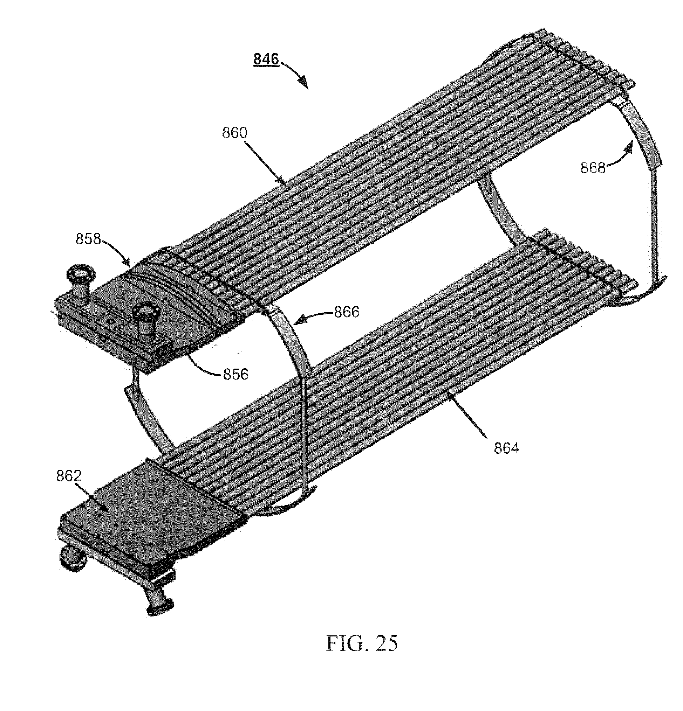

FIG. 25 shows that in a preferred embodiment, the cooling tubes assembly 846 includes an outlet manifold 856 supporting a thermal dispersion baffle 858, and communicating with a plurality of outlet cooling tubes 860. FIG. 25 further shows, that in the preferred embodiment, the cooling tubes assembly 846 includes an inlet manifold 862 communicating with a plurality of inlet cooling tubes 864, and a pair of tube retention assemblies, 866 and 868 respectfully, separating and securing the cooling tubes assemblies 860 and 864 on to the other.

Returning to FIG. 24, the preferred outlet conduit assembly 852 includes an outlet header 870 in communication with the outlet manifold 856, an accumulator 872 cooperating with and disposed between the outlet header 870 and a return line 874. Preferably, the return line 874 interconnects directly with the heat exchanger 854. It is noted that a ThermaSys Heat Exchanger Part No. SSC-1260-0, by ThermaSys Corporation of Montgomery, Alabama, USA, has been found to be useful as a heat exchanger for use in the claimed subject matter, but is not a required heat exchanger for use in the claimed subject matter.

FIG. 24 further shows the preferred inlet conduit assembly 850 includes an inlet header 876 in communication with the inlet manifold 862, an inlet accumulator 878 cooperating with the inlet header 876 and a supply line 880. Also shown by FIG. 24, is a source line 882 connected directly into a first isolation valve 884, which front ends the air handling unit 848, and a second isolation valve 886 disposed between and interconnected directly with each the air handling unit 848 and the supply line 880. The first isolation valve 884 is disposed between and is in fluid communication with, the heat exchanger 854 and the fluid handling unit 848, while the second isolation valve 886 is disposed between and in fluid communication with the fluid handling unit 848 and the cooling tubes assembly 846.

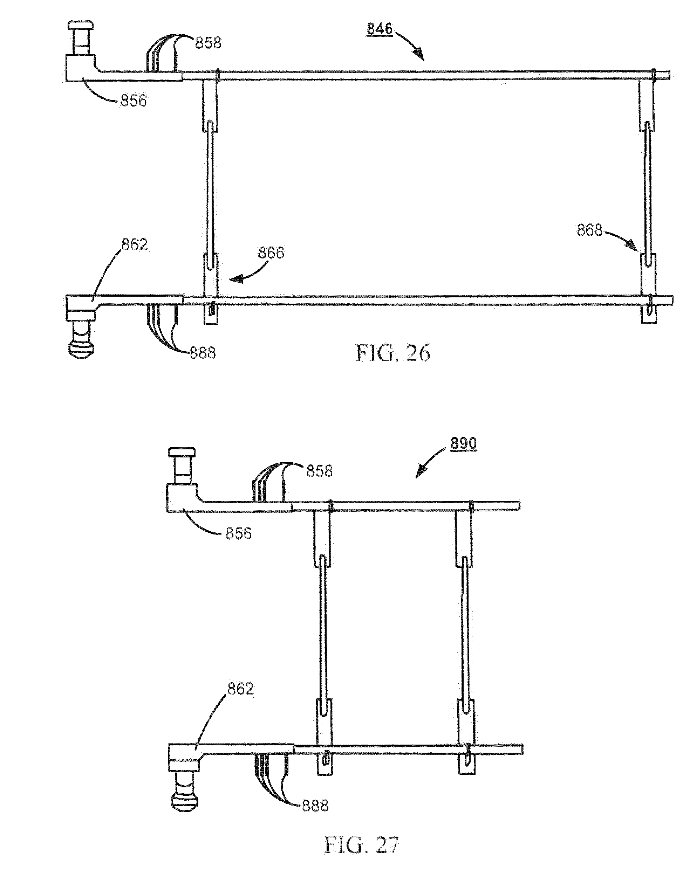

FIG. 26 shows a right side view in elevation of the cooling tubes assembly 846, which preferably includes the outlet manifold 856 supporting the first set of thermal dispersion baffles 858, and the inlet manifold 862 supporting a second thermal dispersion baffle 888.

FIG. 27 depicts a right side view in elevation of a preferred embodiment of a cooling tubes assembly 890, which preferably includes the outlet manifold 856 supporting the first set of thermal dispersion baffles 858, and the inlet manifold 862 supporting a second thermal dispersion baffle 888.

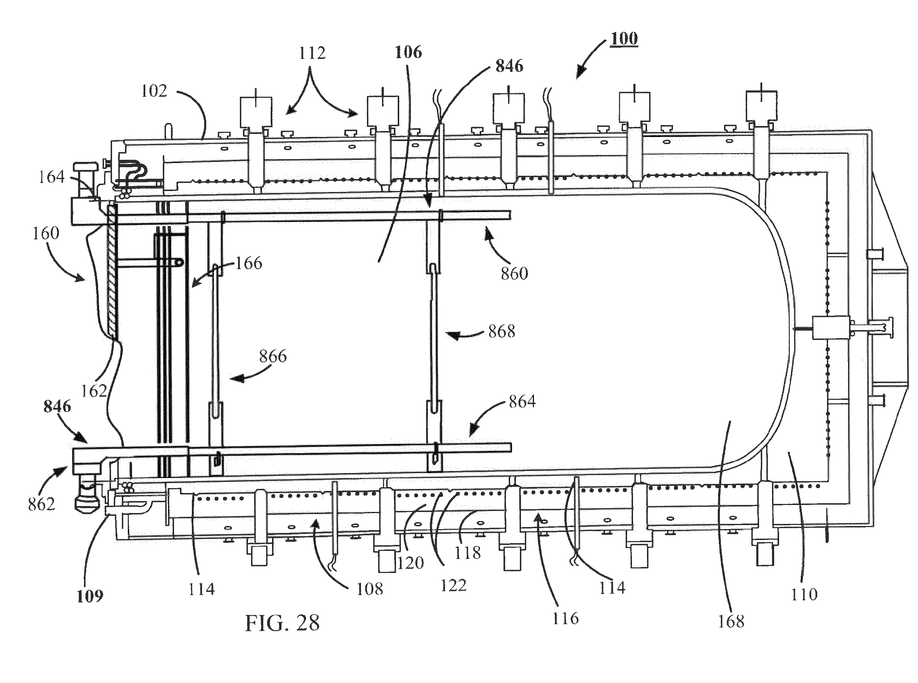

FIG. 28 illustrates in cross section, the cooling tubes assembly 846 positioned within the process chamber 106 of the thermal chamber 100. FIG. 28 further shows the cooling tubes assembly 846 secured to the collar 109. It will be noted that in this embodiment, the outlet cooling tubes 860, project to about the mid-point of the process chamber 106. This particular embodiment has been shown to produce quite favorable results. The remaining sign numbers shown by FIG. 28, replicate the sign numbers for FIG. 6. Accordingly, a review of the discussion of FIG. 6 will aid in an understanding of other structural features of the thermal chamber 100.

Returning again to FIG. 24, the first isolation valve 884 communicates with the heat exchanger 854. In a preferred embodiment, the heat exchanger 854 includes a heat exchange core 892, a fluid input port 894 communicating with the heat exchange core 892, a fluid output port 896 communicating with the heat exchange core 892 and offset from said fluid input port 894, a coolant input port 898 in fluid communication with the heat exchange core 892, and a coolant output port 900 in fluid communication with the heat exchange core 892 and offset from the coolant input port 898 by the heat exchange core 892.

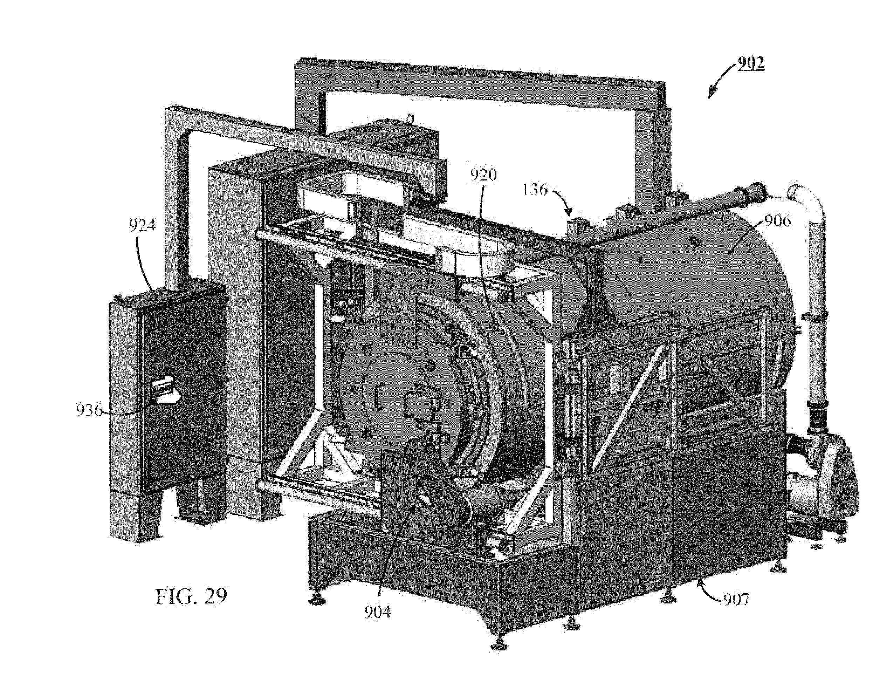

FIG. 29 illustrates an exemplary embodiment of a thermal diffusion chamber 902, with an open loop fluid convection system 904 integrated therewith. The thermal diffusion chamber 902 preferably includes at least a containment chamber 906 supported by a frame 907.

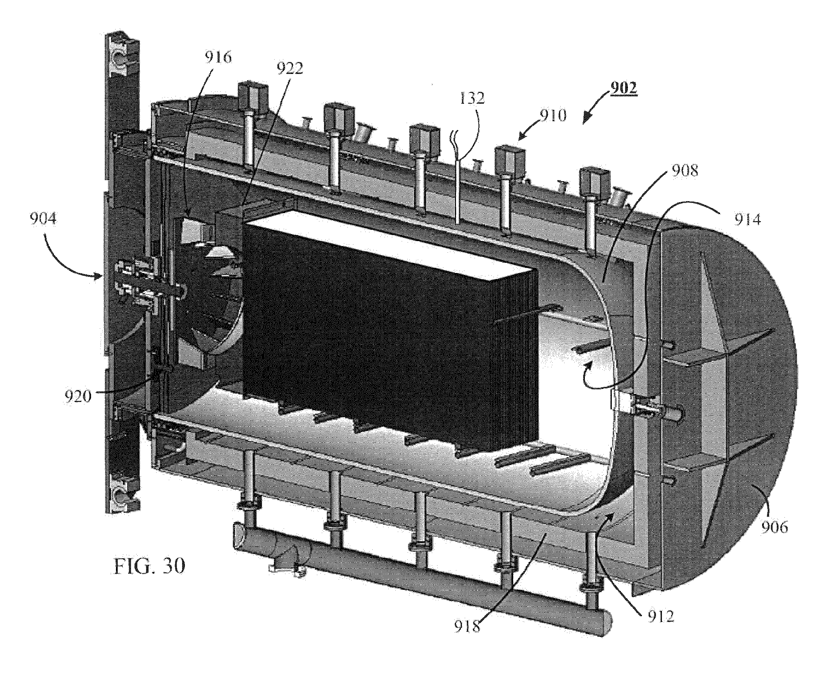

FIG. 30 shows the thermal diffusion chamber 902, preferably further includes a sealed process chamber 908, confined by the containment chamber 906, and a fluid inlet vessel 910, in fluidic communication with an exterior of the sealed process chamber 908. Preferably, the fluid inlet vessel 910 including at least a flow adjustment structure 136 (of FIG. 4), to control a fluid flow from a fluid source 912 around the exterior of the sealed process chamber 908. FIG. 30 further shows that the open loop fluid convection system 904 is preferably in fluidic communication with an interior 914, of the sealed process chamber 908, and that the fluid convection system 904 preferably includes a rotary compressor assembly 916, which is preferably formed from quartz, but may alternatively be formed from titanium or a titanium alloy, and that extends into the sealed process chamber 908.

Additionally, FIG. 30 shows that in a preferred embodiment, the thermal diffusion chamber 902 includes a heat source module 918, disposed between the containment chamber 906, and the process chamber 908, and a thermal sensor assembly 920, disposed within an interior of the sealed process chamber 908, adjacent a wall of the sealed process chamber 908, the thermal sensor assembly 920, measures an internal temperature value of the sealed process chamber 908, and wherein the open loop fluid convection system 904, further at least a shroud 922, which is preferably formed from quartz, but may alternatively be formed from titanium or a titanium alloy, and is adjacent the rotary compressor assembly 916.

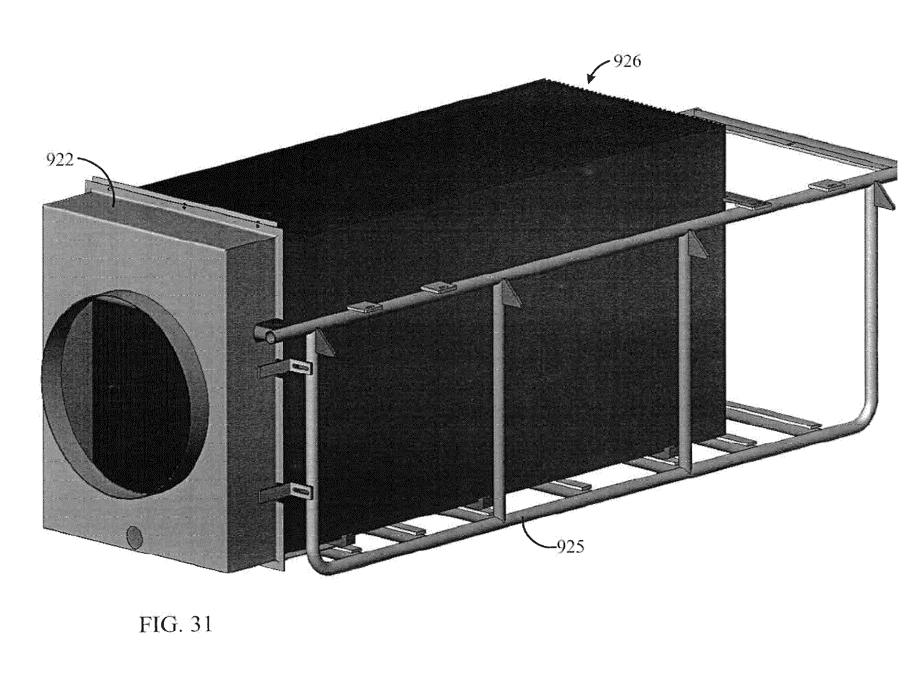

Continuing with FIG. 30, preferably, the thermal diffusion chamber 902 further includes at least, a controller 924 (of FIG. 29), communicating with the flow adjustment structure 136 (of FIG. 29) and the thermal sensor assembly 920, the controller 924 preferably sets a flow position of the flow adjustment structure 136 to regulate fluid flow from the fluid source 912, through the fluid inlet vessel 910, and around the exterior of the sealed process chamber 908, in response to the measured internal temperature value of the sealed process chamber 908, and wherein the shroud 922, which is preferably adjacent the rotary compressor assembly 916, communicates with a substrate support frame 925 (of FIG. 31)

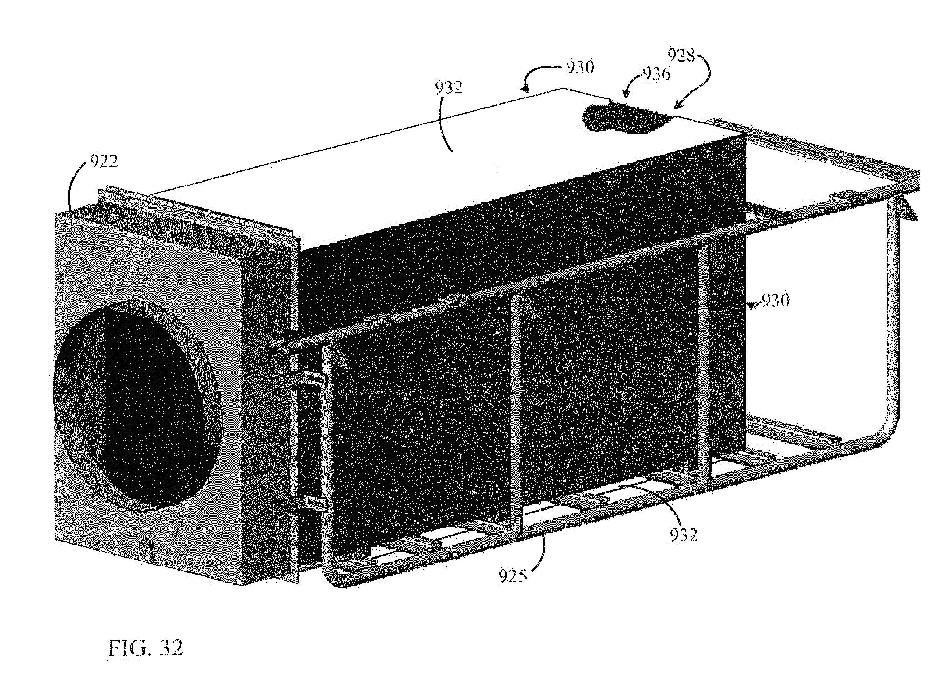

FIG. 31 shows a preferred embodiment of the substrate support frame 925, supporting a plurality of substrates 926, and communicating with the shroud 922, while FIG. 32 reveals a preferred convection conduit 928, formed by a pair of substrates 930, of the plurality of substrates 926, arranged one adjacent each side of the substrate support frame 925, and a pair of flow confinement covers 932, preferably arranged one adjacent each a top side of the substrate support frame 925, and a bottom side of the substrate support frame 925, the convection conduit 928, is preferably adjacent the shroud 922. Both the substrate support frame 925 and the flow confinement covers 912 are preferably formed from quartz, but may alternatively be formed from titanium or a titanium alloy.

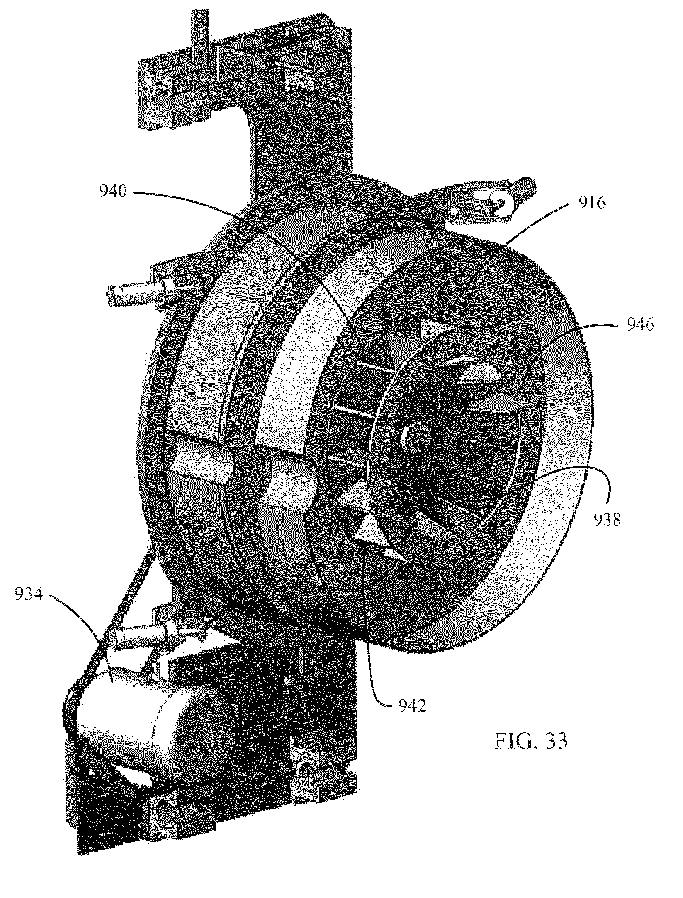

FIG. 33 shows that in a preferred embodiment, a motor 934, communicating with the rotary compressor assembly 916, and a motor controller 936 (of FIG. 29). The motor controller 936 preferably communicating with the motor 934, and responsive to the thermal sensor assembly 920 (of FIG. 30). In a preferred embodiment, the motor 934 is an alternating current electric motor, but as those skilled in the art will recognize, the motor 934 could also be a direct current electric motor, a hydraulic motor, a pneumatic motor, or other rotational motion generating devices.

FIG. 33 further shows that the rotary compressor assembly 916, preferably includes at least a central shaft 938, responsive to the motor 934, a back plate 940, secured to the central shaft 938, for rotation with the central shaft 938, and a plurality of blades 942, radially disposed about the central shaft 938, extending from the back plate 940, and secured to a face plate 946. Preferably, the back plate 940, face plate 946 and the blades 942 are preferably formed from quartz, but may alternatively be formed from titanium or a titanium alloy.

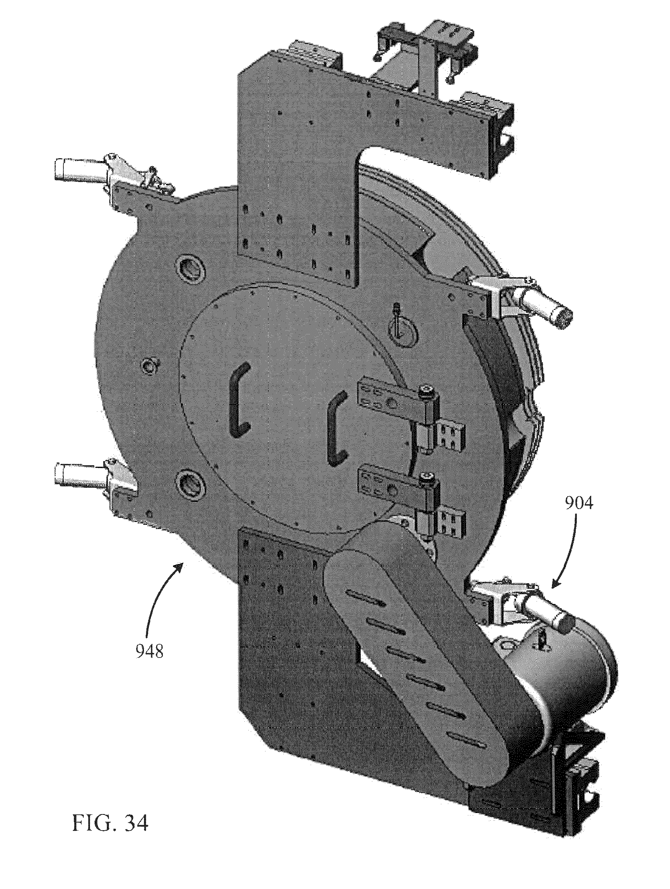

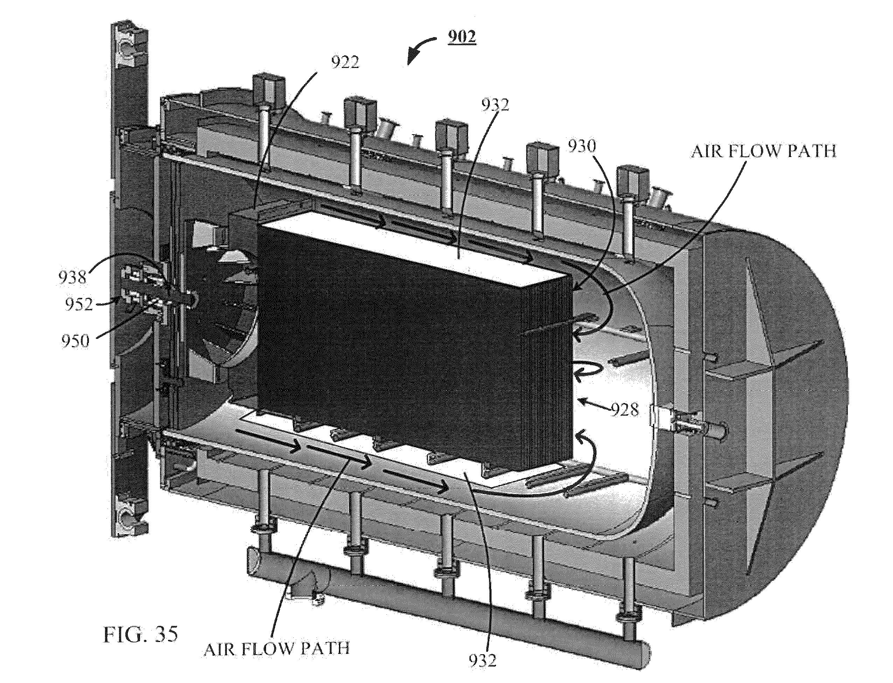

FIG. 34 reveals an external view of the rotary compressor assembly 916, interacting with a door assembly 948, while FIG. 35 shows a portion of a preferred pair of flow confinement covers 932, of the convection conduit 928, in partial cut-away, enclosing the plurality of substrates 930 (of FIG. 32). FIG. 35 further shows that the rotary compressor assembly 916, of the thermal diffusion chamber 902, preferably includes a central shaft bushing 950 (which those skilled in the art may also be a barring assembly), supporting the central shaft 938, and affixed to a door assembly 948 (of FIG. 34), communicating with the sealed process chamber 908. Preferably, the rotary compressor assembly 916 further includes a bushing cooling apparatus 952, cooperating with the central shaft bushing 950, the bushing cooling apparatus 952, is useful in modulating a temperature of the central shaft bushing 950.

Additionally, in a preferred embodiment, as shown by FIG. 35, the convection conduit 928, provides a proximal end adjacent the shroud 922, and a distal end adjacent a closed end of the sealed process chamber 908. In response to an activation of the motor 934 (of FIG. 33), the plurality of blades 942 (of FIG. 33), rotate in unison with the central shaft 938, thereby pulling a fluid confined within the sealed process chamber 908, through the distal end of the convection conduit 928, and past the plurality of substrate panels 930, creating a fluid flow across surfaces of the plurality of substrate panels 930, the fluid flow stabilizes a temperature of each of the plurality of panels to coincide with a temperature of the fluid.

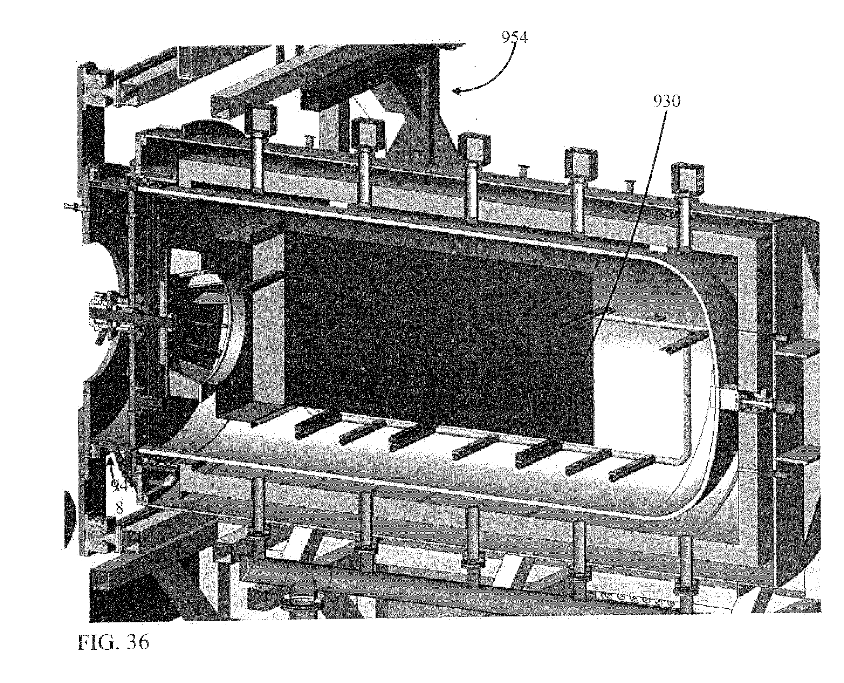

FIG. 36 provides view of a door gurney 954, communicating with the door assembly 948, of the sealed process chamber 908.

It is to be understood that even though numerous characteristics and advantages of various embodiments of the present invention have been set forth in the foregoing description, together with details of the structure and function of various embodiments of the invention, this detailed description is illustrative only, and changes may be made in detail, especially in matters of structure and arrangements of parts within the principles of the present claimed invention to the full extent indicated by the broad general meaning of the terms in which the appended claims are expressed. For example, the particular elements may vary depending on the particular application without departing from the spirit and scope of the present claimed invention.

It will be clear that the present invention is well adapted to attain the ends and advantages mentioned as well as those inherent therein. While presently preferred embodiments have been described for purposes of this disclosure, numerous changes may be made which will readily suggest themselves to those skilled in the art and which are encompassed by the appended claims.

The present invention will now be described by way of reference to the following clauses:
1. An apparatus comprising:
   a frame supporting a containment chamber;
   a process chamber confined within the containment chamber;
   a heat source module disposed between the containment chamber and the process chamber;
   a thermal regulation cavity formed between the heat source module and the process chamber;
   at least one fluid inlet structure in fluidic communication with the thermal regulation cavity, in which the fluid inlet structure provides a valve, the valve controls fluid flow from the thermal regulation cavity through the fluid inlet structure and to an environment external to the thermal regulation cavity, and wherein the fluid inlet structure further includes a flow adjustment structure interacting with the valve to control fluid flow from the environment external to the thermal regulation cavity past the valve and into the thermal regulation cavity; and
   an open loop fluid convection system in fluidic communication with an interior of the process chamber, wherein the fluid convection system includes a rotary compressor assembly that extends into the process chamber.
2. The apparatus of clause 1, in which the process chamber is a sealed process chamber, and further comprising:
   a heat source module disposed between the containment chamber and the process chamber; and
   a thermal sensor assembly disposed within an interior of the sealed process chamber adjacent a wall of the sealed thermal chamber, the thermal sensor assembly measures an internal temperature value of the sealed process chamber, and wherein the open loop fluid convection system further comprising a shroud adjacent the rotary compressor assembly.
3. The apparatus of clause 2, further comprising a controller communicating with the flow adjustment structure and the thermal sensor assembly, the controller sets a flow position of the flow adjustment structure to regulate fluid flow from the fluid source, through the fluid inlet structure, and around the exterior of the sealed process chamber in response to the measured internal temperature value of the sealed process chamber, and wherein the shroud, adjacent the rotary compressor assembly, communicates with a substrate support frame.
4. The apparatus of clause 3, further comprising a convection conduit formed by a pair of substrates arranged one adjacent each side of the substrate support frame, and a pair of flow confinement covers arranged one adjacent each a top side of the substrate support frame and a bottom side of the substrate support frame, the convection conduit adjacent the shroud.
5. The apparatus of clause 4, in which the fluid convection system further comprising:
   a motor in communication with the rotary compressor assembly; and
   a motor controller communicating with the motor and responsive to the thermal sensor assembly.
6. The apparatus of clause 5, in which the motor is an electric motor.
7. The apparatus of clause 5, in which the motor is a rotary hydraulic motor.
8. The apparatus of clause 5, in which the motor is a rotary pneumatic motor.
9. The apparatus of clause 5, in which the rotary compressor assembly comprising:
   a central shaft responsive to the motor;
   a back plate secured to the central shaft for rotation with the central shaft; and
   a plurality of blades radially disposed about the central shaft and extending from the back plate.
10. The apparatus of clause 9, the rotary compressor assembly further comprising, a face plate communicating with the plurality of blades, the plurality of blades disposed between the back plate and the face plate for rotation with the central shaft.
11. An apparatus comprising:
   a frame supporting a containment chamber;
   a process chamber confined within the containment chamber;
   at least one fluid inlet structure in fluidic communication with an exterior of the process chamber, the fluid inlet structure including at least a flow adjustment structure to control a fluid flow from a fluid source around the exterior of the process chamber;
   an open loop fluid convection system in fluidic communication with an interior of the process chamber, wherein the fluid convection system includes a rotary compressor assembly that extends into the process chamber;
   a controller communicating with the flow adjustment structure; and
   a control signal buss communicating with at least the flow adjustment structure, and the controller, the control signal buss sends a control signal to the flow adjustment structure in response to a measured internal temperature value of an interior of said process chamber, wherein the rotary compressor assembly includes a central shaft for rotation within the process chamber.
12. The apparatus of clause 11, in which the sealed process chamber is a process chamber, and the rotary compressor assembly comprising:
   a back plate secured to the central shaft for rotation with the central shaft; and
   a plurality of blades radially disposed about the central shaft and extending from the back plate.
13. The apparatus of clause 12, in which the rotary compressor assembly further comprising, a face plate communicating with the plurality of blades, the plurality of blades disposed between the back plate and the face plate for rotation with the central shaft.
14. The apparatus of clause 13, in which the rotary compressor assembly further comprising:
   a motor communication with the central shaft; and
   a motor controller communicating with the motor and responsive to the measured internal temperature value of an interior of said sealed process chamber.
15. The apparatus of clause 14, further comprising:
   a substrate support frame communicating with the interior volume of the sealed process chamber; and
   a shroud interacting with the substrate support frame and in fluidic communication with the plurality of blades.
16. The apparatus of clause 15, further comprising a convection conduit formed by a pair of substrates arranged one adjacent each side of the substrate support frame, and a pair of flow confinement covers arranged one adjacent each a top side of the substrate support frame and a bottom side of the substrate support frame, the convection conduit adjacent the shroud and in fluidic communication with the plurality of blades.
17. The apparatus of clause 16, in which the rotary compressor assembly further comprising:
   a central shaft bushing supporting the central shaft and affixed to a chamber door communicating with the sealed process chamber; and
   a bushing cooling apparatus cooperating with the central shaft bushing, the bushing cooling apparatus modulating a temperature of the central shaft bushing.
18. The apparatus of clause 17, in which the convection conduit provides a proximal end adjacent the shroud, and a distal end adj acent a closed end of the sealed process chamber.
19. The apparatus of clause 18, in which the substrate support frame supports a plurality of substrate panels, the substrate panels extending from a proximal end of the substrate support frame adjacent the shroud to a distal end of the substrate support frame adjacent the closed end of the sealed process chamber, the plurality of substrate panels disposed within the convection conduit.
20. The apparatus of clause 18, in which in response to an activation of a motor, the plurality of blades rotate in unison with the central shaft, thereby pulling a fluid confined within the sealed process chamber through the convection conduit and past the plurality of substrate panels creating a fluid flow across surfaces of the plurality of substrate panels, the fluid flow stabilizes a temperature of each of the plurality of panels to coincide with a temperature of the fluid.

## Claims

1. An apparatus comprising:
a frame supporting a containment chamber;
a process chamber confined within the containment chamber;
a heat source module disposed between the containment chamber and the process chamber;
a thermal regulation cavity formed between the heat source module and the process chamber;
at least one fluid inlet structure in fluidic communication with the thermal regulation cavity, in which the fluid inlet structure provides a valve, the valve controls fluid flow from the thermal regulation cavity through the fluid inlet structure and to an environment external to the thermal regulation cavity, and wherein the fluid inlet structure further includes a flow adjustment structure interacting with the valve to control fluid flow from the environment external to the thermal regulation cavity past the valve and into the thermal regulation cavity; and
an open loop fluid convection system in fluidic communication with an interior of the process chamber, wherein the fluid convection system includes a rotary compressor assembly that extends into the process chamber.

2. The apparatus of claim 1, in which the process chamber is a sealed process chamber, and further comprising:
a heat source module disposed between the containment chamber and the process chamber; and
a thermal sensor assembly disposed within an interior of the sealed process chamber adjacent a wall of the sealed thermal chamber, the thermal sensor assembly measures an internal temperature value of the sealed process chamber, and wherein the open loop fluid convection system further comprising a shroud adjacent the rotary compressor assembly.

3. The apparatus of claim 2, further comprising a controller communicating with the flow adjustment structure and the thermal sensor assembly, the controller sets a flow position of the flow adjustment structure to regulate fluid flow from the fluid source, through the fluid inlet structure, and around the exterior of the sealed process chamber in response to the measured internal temperature value of the sealed process chamber, and wherein the shroud, adjacent the rotary compressor assembly, communicates with a substrate support frame.

4. The apparatus of claim 3, further comprising a convection conduit formed by a pair of substrates arranged one adjacent each side of the substrate support frame, and a pair of flow confinement covers arranged one adjacent each a top side of the substrate support frame and a bottom side of the substrate support frame, the convection conduit adjacent the shroud.

5. The apparatus of claim 4, in which the fluid convection system further comprising:
a motor in communication with the rotary compressor assembly; and
a motor controller communicating with the motor and responsive to the thermal sensor assembly; and
wherein preferably the motor is selected from a group consisting of an electric motor, a rotary hydraulic motor, and a rotary pneumatic motor.

6. The apparatus of claim 5, in which the rotary compressor assembly comprising:
a central shaft responsive to the motor;
a back plate secured to the central shaft for rotation with the central shaft; and
a plurality of blades radially disposed about the central shaft and extending from the back plate; and
wherein preferably the rotary compressor assembly further comprising, a face plate communicating with the plurality of blades, the plurality of blades disposed between the back plate and the face plate for rotation with the central shaft.

7. An apparatus comprising:
a frame supporting a containment chamber;
a process chamber confined within the containment chamber;
at least one fluid inlet structure in fluidic communication with an exterior of the process chamber, the fluid inlet structure including at least a flow adjustment structure to control a fluid flow from a fluid source around the exterior of the process chamber;
an open loop fluid convection system in fluidic communication with an interior of the process chamber, wherein the fluid convection system includes a rotary compressor assembly that extends into the process chamber;
a controller communicating with the flow adjustment structure; and
a control signal buss communicating with at least the flow adjustment structure, and the controller, the control signal buss sends a control signal to the flow adjustment structure in response to a measured internal temperature value of an interior of said process chamber, wherein the rotary compressor assembly includes a central shaft for rotation within the process chamber.

8. The apparatus of claim 7, in which the sealed process chamber is a process chamber, and the rotary compressor assembly comprising:
a back plate secured to the central shaft for rotation with the central shaft; and
a plurality of blades radially disposed about the central shaft and extending from the back plate; and
wherein preferably the rotary compressor assembly further comprising, a face plate communicating with the plurality of blades, the plurality of blades disposed between the back plate and the face plate for rotation with the central shaft.

9. The apparatus of claim 8, in which the rotary compressor assembly further comprising:
a motor communication with the central shaft; and
a motor controller communicating with the motor and responsive to the measured internal temperature value of an interior of said sealed process chamber.

10. The apparatus of claim 9, further comprising:
a substrate support frame communicating with the interior volume of the sealed process chamber; and
a shroud interacting with the substrate support frame and in fluidic communication with the plurality of blades.

11. The apparatus of claim 10, further comprising a convection conduit formed by a pair of substrates arranged one adjacent each side of the substrate support frame, and a pair of flow confinement covers arranged one adjacent each a top side of the substrate support frame and a bottom side of the substrate support frame, the convection conduit adjacent the shroud and in fluidic communication with the plurality of blades.

12. The apparatus of claim 11, in which the rotary compressor assembly further comprising:
a central shaft bushing supporting the central shaft and affixed to a chamber door communicating with the sealed process chamber; and
a bushing cooling apparatus cooperating with the central shaft bushing, the bushing cooling apparatus modulating a temperature of the central shaft bushing.

13. The apparatus of claim 12, in which the convection conduit provides a proximal end adjacent the shroud, and a distal end adj acent a closed end of the sealed process chamber.

14. The apparatus of claim 13, in which the substrate support frame supports a plurality of substrate panels, the substrate panels extending from a proximal end of the substrate support frame adjacent the shroud to a distal end of the substrate support frame adjacent the closed end of the sealed process chamber, the plurality of substrate panels disposed within the convection conduit.

15. The apparatus of claim 13, in which in response to an activation of a motor, the plurality of blades rotate in unison with the central shaft, thereby pulling a fluid confined within the sealed process chamber through the convection conduit and past the plurality of substrate panels creating a fluid flow across surfaces of the plurality of substrate panels, the fluid flow stabilizes a temperature of each of the plurality of panels to coincide with a temperature of the fluid.
